(19) Europäisches Patentamt
European Patent Office
Office européen des brevets

(11) **EP 1 653 791 A2**

(12) **EUROPEAN PATENT APPLICATION**

(43) Date of publication:
**03.05.2006 Bulletin 2006/18**

(51) Int Cl.:
***H05K 9/00*** (2006.01)

(21) Application number: **05023428.5**

(22) Date of filing: **26.10.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **28.10.2004 JP 2004314036**

(71) Applicant: **NITTO DENKO CORPORATION Osaka (JP)**

(72) Inventors:
- **Sano, Masanori**
  **Ibaraki-shi**
  **Osaka (JP)**

- **Konishi, Toshiharu**
  **Ibaraki-shi**
  **Osaka (JP)**
- **Imono, Shozo**
  **Ibaraki-shi**
  **Osaka (JP)**
- **Niino, Takuya**
  **Ibaraki-shi**
  **Osaka (JP)**

(74) Representative: **Grünecker, Kinkeldey, Stockmair & Schwanhäusser Anwaltssozietät Maximilianstrasse 58 80538 München (DE)**

(54) **Structure having a characteristic of conducting or absorbing electromagnetic waves**

(57) A structure having a characteristic of conducting or absorbing electromagnetic waves contains a base material having a characteristic of conducting or absorbing electromagnetic waves, a pressure-sensitive adhesive layer or an adhesive layer formed on at least one surface thereof, and a fiber convex structure section having a characteristic of conducting or absorbing electromagnetic waves formed on the pressure-sensitive adhesive layer or adhesive layer on the at least one surface of the base material in a form that at least a part of a fiber thereof is positioned outward from the surface of the pressure-sensitive adhesive layer or adhesive layer.

## FIG. 1A

**Description**

FIELD OF THE INVENTION

The present invention relates to a structure having a characteristic of conducting or absorbing electromagnetic waves.

BACKGROUND OF THE INVENTION

In various kinds of joining (especially, joining of electronic parts) for which a pressure-sensitive adhesive tape is used, it has been frequently required to have a characteristic of conducting or absorbing electromagnetic waves such as electrical conductivity and electromagnetic shielding properties. For that reason, with respect to a method for providing (bringing) a characteristic of conducting or absorbing electromagnetic waves such as electrical conductivity and electromagnetic shielding properties in a pressure-sensitive adhesive tape, there have hitherto been made a lot of investigations. For example, as materials having electrical conductivity or electromagnetic shielding properties, there are proposed an electrically conductive mutual connecting material obtained by non-random single layer coating of a particle (see JP-T-2002-501821 (the term "JP-T" as used herein means an "unexamined published International patent application")); an electrically conductive sealing material obtained by blending a silica powder, carbon black and a metal powder in a silicon rubber (see JP-A-10-120904 (the term "JP-A" as used herein means an "unexamined published Japanese patent application")); and so on. As materials having electrical conductivity or electromagnetic shielding properties, there is also proposed a high molecular molded body having electromagnetic shielding properties in which a flock composed of an electrically conductive fiber is flocked and fixed on a high molecular substrate and electrical conductivity is imparted between flocks on the roots of the flocks (see JP-A-61-2394).

For the purpose of keeping electrical conductivity, it is required in the foregoing electrically conductive mutual connecting material that a particle having electrical conductivity be regularly aligned. If it is possible to regularly align the particle having electrical conductivity, though such is certainly useful in view of the electrical conductivity, what the particle be regularly aligned is very complicated and is accompanied with difficulty in steps.

Furthermore, the foregoing electrically conductive sealing material is provided with electrical conductivity by kneading a particle having electrical conductivity into a resin of every kind. For that reason, the preparation method of this case is simple, and there is a less problem in view of steps. However, in order to impart electrical conductivity, a large amount of the electrically conductive particle must be blended, and as a result, there was involved a defect that the costs are comparatively high. Moreover, since a large amount of the electrically conductive particle is blended, there was also involved a defect that other characteristics are affected.

In addition, since the foregoing high molecular molded body having electromagnetic shielding properties has a construction in which an electrically conductive fiber is flocked on a high molecular substrate by using an adhesive layer having electrical conductivity, etc., though the electromagnetic shielding properties is improved, it cannot be said that such an improvement is sufficient. Thus, a structure having much more excellent electromagnetic shielding properties is demanded. Moreover, since the electrically conductive fiber is merely flocked in the adhesive layer having electrical conductivity, it is liable to come out. The electrically conductive fiber which has come out from the adhesive layer having electrical conductivity becomes a dust or adversely affects a device into which the high molecular molded body having electromagnetic shielding properties is installed or surrounding instruments thereof. Thus, in the case of using an electrically conductive fiber, good retention of the electrically conductive fiber is demanded.

SUMMARY OF THE INVENTION

Accordingly, an object of the invention is to provide a structure which has a characteristic of conducting or absorbing electromagnetic waves at an excellent level and which is produced easily and cheaply.

Another object of the invention is to provide a structure which can be suitably applied as an electrically conductive material or an electromagnetic shielding material.

In order to achieve the foregoing objects, the present inventors made extensive and intensive investigations. As a result, it has been found that by providing a specific structure section composed of a fiber having electrical conductivity in a pressure-sensitive adhesive layer, not only it is possible to impart electrical conductivity to a member having the subject pressure-sensitive adhesive layer, but also it can be prepared easily and cheaply. In particular, it has been found that by providing a specific structure section composed of a fiber having electrical conductivity partially in a pressure-sensitive adhesive layer, it is possible to impart electrical conductivity without impairing a pressure-sensitive adhesive characteristic which is original in a pressure-sensitive adhesive layer to a considerable extent. The invention has been accomplished on the basis of these findings.

Specifically, the invention is concerned with a structure having a characteristic of conducting or absorbing electromagnetic waves, which comprises a base material having a characteristic of conducting or absorbing electromagnetic waves; a pressure-sensitive adhesive layer or an adhesive layer formed on at least one surface thereof; and a fiber convex structure section having a characteristic of conducting or absorbing electromagnetic waves formed on the pressure-sensitive adhesive layer or adhesive layer on the at least one surface of the base material in a form that at least a part of a fiber thereof is positioned outward from the surface of the pressure-sensitive adhesive layer or adhesive layer.

In the foregoing structure, it is preferable that the pressure-sensitive adhesive layer or adhesive layer has a characteristic of conducting or absorbing electromagnetic waves. Further, a base material containing a material having a characteristic of conducting or absorbing electromagnetic waves on the surface or inside thereof, or a fibrous base material having a characteristic of conducting or absorbing electromagnetic waves can be suitably used as the base material having a characteristic of conducting or absorbing electromagnetic waves.

Also, the invention is concerned with a structure having a characteristic of conducting or absorbing electromagnetic waves, which comprises a substrate having formed thereon a fiber convex structure section having a characteristic of conducting or absorbing electromagnetic waves in a form that at least a part of a fiber thereof is positioned outward from the surface of the substrate, the fiber convex structure section being coated by a coating layer.

In the foregoing structure, it is preferable that the coating layer has a characteristic of conducting or absorbing electromagnetic waves. Further, the substrate is suitably at least one layer selected from a pressure-sensitive adhesive layer, an adhesive layer, and a polymer layer and preferably has a characteristic of conducting or absorbing electromagnetic waves. Moreover, the substrate may be formed on at least one surface of a support; and the subject support is a base material containing a material having a characteristic of conducting or absorbing electromagnetic waves on the surface or inside thereof, a foamed body, or a fibrous base material having a characteristic of conducting or absorbing electromagnetic waves.

In addition, the invention is concerned with a structure having a characteristic of conducting or absorbing electromagnetic waves, which comprises a pressure-sensitive adhesive layer having formed on one surface of the pressure-sensitive adhesive layer a fiber convex structure section having a characteristic of conducting or absorbing electromagnetic waves in a form that at least a part of a fiber thereof is positioned outward from the surface of the pressure-sensitive adhesive layer, the other surface of the pressure-sensitive adhesive layer serving as a pressure-sensitive adhesive surface.

In the foregoing structure, it is preferable that the pressure-sensitive adhesive layer has a characteristic of conducting or absorbing electromagnetic waves.

In addition, the invention is concerned with a structure having a characteristic of conducting or absorbing electromagnetic waves, which comprises a substrate having formed on each of the both surfaces thereof a fiber convex structure section having a characteristic of conducting or absorbing electromagnetic waves in a form that at least a part of a fiber thereof is positioned outward from each of the surfaces of the substrate.

In the foregoing structure, the substrate is suitably at least one layer selected from a pressure-sensitive adhesive layer, an adhesive layer, and a polymer layer and preferably has a characteristic of conducting or absorbing electromagnetic waves.

As such a structure of the form of every kind, a sheet-like structure having a sheet form is suitable.

In these structures of the invention, the fiber convex structure section having a characteristic of conducting or absorbing electromagnetic waves is suitably a fiber napping section having a characteristic of conducting or absorbing electromagnetic waves and having a structure that a fiber stands up from the formed surface and is preferably constructed of at least one kind of a fiber having a characteristic of conducting or absorbing electromagnetic waves selected from a fiber coated by a material having a characteristic of conducting or absorbing electromagnetic waves, a fiber impregnated with a material having a characteristic of conducting or absorbing electromagnetic waves, and a fiber having itself a characteristic of conducting or absorbing electromagnetic waves. Such a fiber convex structure section may be formed by flocking a fiber having a characteristic of conducting or absorbing electromagnetic waves. Also, it is preferable that the fiber convex structure section is constructed of a twisted yarn using two or more kinds of fibers having a characteristic of conducting or absorbing electromagnetic waves.

The structure of the invention can be suitably applied as an electrically conductive material or an electromagnetic shielding material.

BRIEF DESCRIPTION OF THE DRAWINGS

Figs. 1A and 1B each is an outline view to partially show one example of an electromagnetic conducting and absorbing fiber convex section in the structure of the invention; and Fig. 1A is an outline plan view as seen from the upper surface of the structure, while Fig. 1B is an outline cross-sectional view of an X-Y line in Fig. 1A.

Figs. 2A and 2B each is an outline view to partially show another example of an electromagnetic conducting and absorbing fiber convex section in the structure of the invention; and Fig. 2A is an outline plan view as seen from the upper surface of the structure, while Fig. 2B is an outline cross-sectional view of an X'-Y' line in Fig. 2A.

Figs. 3A and 3B each is an outline view to partially show a still another example of an electromagnetic conducting and absorbing fiber convex section in the structure of the invention; and Fig. 3A is an outline plan view as seen from the upper surface of the structure, while Fig. 3B is an outline cross-sectional view of an X"-Y" line in Fig. 3A.

Figs. 4A, 4B and 4C each is an outline cross-sectional view to show an example of a coating layer in the structure (B) .

Figs. 5A, 5B and 5C each is an outline cross-sectional view to show one example of the structure of the invention.

Figs. 6A, 6B, 6C, 6D and 6E each is an outline cross-sectional view to show another example of the structure of the invention.

Fig. 7 is an outline cross-sectional view to show a still another example of the structure of the invention.

Fig. 8 is an outline cross-sectional view to show an even another example of the structure of the invention.

Fig. 9 is a view to show a graph regarding an electrical fielding effect of Table 1.

Fig. 10 is a view to show a graph regarding an electrical field shielding effect of Table 2.

Fig. 11 is a view to show a graph regarding an electrical field shielding effect of Table 3.

Fig. 12 is a view to show a graph regarding an electrical field shielding effect of Table 4.

Fig. 13 is a view to show a graph regarding an electrical field shielding effect of Table 5.

Fig. 14 is a view to show a graph regarding an electrical field shielding effect of Table 6.

Fig. 15 is a view to show a graph regarding a magnetic field shielding effect of Table 7.

Fig. 16 is a view to show a graph regarding a magnetic field shielding effect of Table 8.

Fig. 17 is a view to show a graph regarding a magnetic field shielding effect of Table 9.

Fig. 18 is a view to show a graph regarding a magnetic field shielding effect of Table 10.

Fig. 19 is a view to show a graph regarding a magnetic field shielding effect of Table 11.

Fig. 20 is a view to show a graph regarding a magnetic field shielding effect of Table 12.

Figs. 21A and 21B each is an outline view to show a shielding box to be used in an electromagnetic shielding evaluation system by the KEC method; and Fig. 21A shows a shielding box for electrical field, while Fig. 21B shows a shielding box for magnetic field.

Description of Reference Numerals and Signs

1: Structure
1a: Pressure-sensitive adhesive layer
1a1: Surface of pressure-sensitive adhesive layer 1a
1b: Electromagnetic conducting or absorbing base material
1c: Electromagnetic conducing or absorbing fiber napping section
2: Structure
2a: Pressure-sensitive adhesive layer
2a1: Surface of pressure-sensitive adhesive layer 2a
2b: Electromagnetic conducting or absorbing base material
2c: Release liner
2c1: Hole section of release liner 2c
2d: Electromagnetic conducting or absorbing fiber napping section
3: Structure
3a: Pressure-sensitive adhesive layer
3al: Concave of pressure-sensitive adhesive layer 3a
3ala: Wall surface of concave 3a1 of pressure-sensitive adhesive layer 3a
3a2: Surface of pressure-sensitive adhesive layer 3a
3b: Electromagnetic conducting or absorbing base material
3c: Hole section-containing release liner
3c1: Hole section of release liner 3c
3d: Electromagnetic conducting or absorbing fiber napping section
41 to 43: Structure (B)
4a: Substrate
4b: Electromagnetic conducting or absorbing fiber convex structure section
4c1 to 4c3: Coating layer
51 to 53: Structure (A)

5a: Electromagnetic conducting or absorbing base material
5b: Pressure-sensitive adhesive or adhesive layer
5c: Electromagnetic conducting or absorbing fiber convex structure section
61 to 65: Structure (B)
6a: Substrate
6b: Electromagnetic conducting or absorbing fiber convex structure section
6c: Coating layer
6d: Base material
6e: Pressure-sensitive adhesive or adhesive layer
7: Structure (C)
7a: Pressure-sensitive adhesive layer
7b: Electromagnetic conducting or absorbing fiber convex structure section
8: Structure (D)
8a: Substrate
8b: Electromagnetic conducting or absorbing fiber convex structure section

DETAILED DESCRIPTION OF THE INVENTION

The structure of the invention is a structure having a characteristic of conducting or absorbing electromagnetic waves and has any one of the following constructions (A) to (D).

(A) A construction comprising a base material having a characteristic of conducting or absorbing electromagnetic waves (the base material being hereinafter sometimes referred to as "electromagnetic conducting or absorbing base material"); a pressure-sensitive adhesive layer or an adhesive layer (hereinafter sometimes referred to as "pressure-sensitive adhesive or adhesive layer") formed on at least one surface of the electromagnetic conducting or absorbing base material; and a fiber convex structure section having a characteristic of conducting or absorbing electromagnetic waves (the fiber convex structure section being hereinafter sometimes referred to as "electromagnetic conducting or absorbing fiber convex structure section") formed on the pressure-sensitive adhesive or adhesive layer on the at least one surface of the electromagnetic conducting or absorbing base material in a form that at least a part of a fiber thereof is positioned outward from the surface of the pressure-sensitive adhesive or adhesive layer.
(B) A construction comprising a substrate having formed thereon an electromagnetic conducting or absorbing fiber convex structure section in a form that at least a part of a fiber thereof is positioned outward from the surface of the substrate, the electromagnetic conducting or absorbing fiber convex structure section being coated by a coating layer.
(C) A construction comprising a pressure-sensitive adhesive layer having formed on one surface of the pressure-sensitive adhesive layer an electromagnetic conducting or absorbing fiber convex structure section in a form that at least a part of a fiber thereof is positioned outward from the surface of the pressure-sensitive adhesive layer, the other surface of the pressure-sensitive adhesive layer serving as a pressure-sensitive adhesive surface.
(D) A construction comprising a substrate having formed on each of the both surfaces of the substrate a fiber convex structure section having a characteristic of conducting or absorbing electromagnetic waves in a form that at least a part of a fiber thereof is positioned outward from each of the surfaces of the substrate.

In the light of the above, since the structure of the invention has at least an electromagnetic conducting or absorbing fiber convex structure section, it can exhibit a characteristic of conducting or absorbing electromagnetic waves (hereinafter sometimes referred to as "electromagnetic conducting or absorbing properties") at an excellent level.
In particular, in the structure having the construction (A) (hereinafter sometimes referred to as "structure (A)"), since the electromagnetic conducting or absorbing base material is used, the electromagnetic conducting or absorbing properties are much more enhanced. Incidentally, in the case where the structure (A) has a construction that the electromagnetic conducting or absorbing fiber convex structure section is formed on each of the both surfaces of the electromagnetic conducting or absorbing base material, it is possible to much more enhance the electromagnetic conducting or absorbing properties. Moreover, not only the electromagnetic conducting or absorbing base material can be made thin and designed to achieve lightening, but also flexibility or follow-up properties (follow-up properties to an adherend) can be improved.
Furthermore, in the structure having the construction (B) (hereinafter sometimes referred to as "structure (B)"), since the coating layer is provided, the fiber which constructs the electromagnetic conducting or absorbing fiber convex structure section is suppressed or prevented from occurrence of coming out from the substrate. In addition, in the structure having the construction (C) (hereinafter sometimes referred to as "structure (C)"), since the surface in the side in which the electromagnetic conducting or absorbing fiber convex structure section is not formed serves as a pressure-sensitive adhesive surface (the surface of a pressure-sensitive adhesive layer), sticking can be performed by utilizing the subject pressure-sensitive adhesive surface. In addition, in the structure having the construction (D) (hereinafter sometimes referred to as "structure (D)"), since the electromagnetic conducting or absorbing fiber convex structure section is formed on each of the both surfaces of the substrate, the electromagnetic conducting or absorbing properties are much more enhanced. Moreover, since the base material is not used, not only lightening can be achieved, but also flexibility or follow-up properties can be improved.

(Electromagnetic conducting or absorbing fiber convex structure section)

In the structure of the invention, the electromagnetic conducting or absorbing fiber convex structure section is formed on the pressure-sensitive adhesive or adhesive layer or substrate (for example, a polymer layer) in a form that at least a part of a fiber thereof is positioned outward (in the outer surface side) from the surface of the substrate. With respect to the foregoing electromagnetic conducting or absorbing fiber convex structure section, the form or construction thereof is not particularly limited so far as it is formed in a form that at least a part of a fiber thereof is positioned outward from the pressure-sensitive adhesive or adhesive layer or substrate and has electromagnetic conducting or absorbing properties. For example, the surface on which the electromagnetic conducting or absorbing fiber convex structure section is formed is not particularly limited but can be properly set up depending upon the layer construction of each of the structures (A) to (D). In the structure (A), examples of the surface on which the electromagnetic conducting or absorbing fiber convex structure section is formed include the surface of the pressure-sensitive adhesive or adhesive layer and the wall surface of a concave which is partially formed in the pressure-sensitive adhesive or adhesive layer. Furthermore, in the structure (B), examples of the surface on which the electromagnetic conducting or absorbing fiber convex structure section is formed include the surface of the substrate (for example, the surface of a pressure-sensitive adhesive or adhesive layer and the surface of a polymer layer) and the wall surface of a concave which is partially formed in the substrate (for example, the wall surface of a concave which is partially formed in the pressure-sensitive adhesive or adhesive layer and the wall surface of a concave which is partially formed in the polymer layer). In addition, in the structure (C), examples of the surface on which the electromagnetic conducting or absorbing fiber convex structure section is formed include the surface of the pressure-sensitive adhesive or adhesive layer and the wall surface of a concave which is partially formed in the pressure-sensitive adhesive or adhesive layer. Moreover, in the structure (D), examples of the surface on which the electromagnetic conducting or absorbing fiber convex structure section is formed include the surface of the substrate and the wall surface of a concave which is partially formed on the substrate likewise the case of the structure (B).

Concretely, examples of the construction of the electromagnetic conducting or absorbing fiber convex structure section include (1) a construction in which the electromagnetic conducting or absorbing fiber convex structure section is formed at least partially (entirely or partially) on the surface of the pressure-sensitive adhesive or adhesive layer or substrate; and (2) a construction in which a concave is partially formed in the pressure-sensitive adhesive or adhesive layer or substrate and the electromagnetic conducting or absorbing fiber convex structure section is formed on the wall surface of this concave in a form that at least a part of a fiber thereof is protruded outward (in the external side) from the surface of the pressure-sensitive adhesive or adhesive layer or substrate. Incidentally, in the structure (D), since the electromagnetic conducting or absorbing fiber convex structure section is formed on each of the both surfaces of the substrate, the construction of the electromagnetic conducting or absorbing fiber convex structure section formed on each surface of the substrate may be one in which the construction on the both surfaces is either the foregoing construction (1) or (2) or one in which the construction on one surface is the foregoing construction (1), while the construction on the other surface is the foregoing construction (2).

With respect to the construction of such an electromagnetic conducting or absorbing fiber convex structure section, in the foregoing construction (1), since the electromagnetic conducting or absorbing fiber convex structure section is formed on the surface of the pressure-sensitive adhesive or adhesive layer or substrate, it may be said that this construction has a construction having a portion in which all fibers are positioned outward from the surface of the pressure-sensitive adhesive or adhesive layer or substrate. Furthermore, in the foregoing construction (2), since the electromagnetic conducting or absorbing fiber convex structure section is formed on the wall surface of a concave in the pressure-sensitive adhesive or adhesive layer or substrate, it may be said that this construction has a construction having a portion in which at least a part of the fiber (moreover, a part of one fiber) is positioned outward from the surface of the pressure-sensitive adhesive or adhesive layer or substrate. In this way, in the electromagnetic conducting or absorbing fiber convex structure section, it is not always required that all fibers are positioned outward (in the external side) from the surface of the pressure-sensitive adhesive or adhesive layer or substrate. It is only required that at least a part of the fiber (for example, in the case where the electromagnetic conducting or absorbing fiber convex structure section is formed on the wall surface of a concave of the pressure-sensitive adhesive or adhesive layer, a fiber formed in the upper side of the wall surface of the concave of the pressure-sensitive adhesive or adhesive layer) is positioned outward from the surface of the pressure-sensitive adhesive or adhesive layer or substrate.

Furthermore, as the fiber which is positioned outward from the surface of the pressure-sensitive adhesive or adhesive layer or substrate, it is not always required that the full length of one fiber is positioned outward from the surface of the pressure-sensitive adhesive or adhesive layer or substrate. It is only required that at least a part of one fiber is positioned outward from the surface of the pressure-sensitive adhesive or adhesive layer or substrate.

In addition, in the case where the electromagnetic conducting or absorbing fiber convex structure section is formed on the wall surface of a concave in the pressure-sensitive adhesive or adhesive layer or substrate, it is not always required that the electromagnetic conducting or absorbing fiber convex structure section is formed on the entire surface of the wall surface of the concave of the pressure-sensitive adhesive or adhesive layer or substrate. It is only required that the electromagnetic conducting or absorbing fiber convex structure section is formed in at least a part of the wall surface of the concave of the pressure-sensitive adhesive or adhesive layer or substrate.

Incidentally, in the case where the electromagnetic conducting or absorbing fiber convex structure section is formed on the wall surface of a concave in the pressure-sensitive adhesive layer, the concave of the pressure-sensitive adhesive layer is a hole section (through-hole section) as described later, and the pressure-sensitive adhesive layer contains, as a support, a pressure-sensitive adhesive tape or a release liner for sheet (that is, in the case where the pressure-sensitive adhesive layer is a pressure-sensitive adhesive layer in a double-sided pressure-sensitive adhesive tape or sheet of a base material-less type) as described below, the hole section as the concave of the pressure-sensitive adhesive layer is an open section in the both surface sides of the pressure-sensitive adhesive layer. Thus, as the surface of the pressure-sensitive adhesive layer in which at least a part of the fiber of the electromagnetic conducting or absorbing fiber convex structure section is positioned protruded outward from the surface of the pressure-sensitive adhesive layer, at least one surface of the pressure-sensitive adhesive layer, and preferably the surface in one side of the pressure-sensitive adhesive layer can be employed. As a matter of course, in the case where the concave of the pressure-sensitive adhesive layer is a depressed section as described below, or in the case where the pressure-sensitive adhesive layer is formed on a base material such as an electromagnetic conducting or absorbing base material (that is, in the case where the pressure-sensitive adhesive layer is a pressure-sensitive adhesive layer in a pressure-sensitive adhesive tape or sheet of a base material-provided type as described below), since in the concave section (for example, the depressed section and the hole section), only one side of the pressure-sensitive adhesive layer is an open section, the surface of the pressure-sensitive adhesive layer which becomes the subject open section can be made so as to serve as the surface of the pressure-sensitive adhesive layer in which at least a part of the fiber of the electromagnetic conducting or absorbing fiber convex structure section is positioned protruded outward from the surface of the pressure-sensitive adhesive layer.

The electromagnetic conducting or absorbing fiber convex structure section may be a structure section having a shape in which at least a part of the fiber is positioned outward from the surface of the pressure-sensitive adhesive or adhesive layer or substrate and the shape is formed in a convex shape due to the fiber and having electromagnetic conducting or absorbing properties. Examples thereof include a fiber napping section having electromagnetic conducting or absorbing properties (hereinafter sometimes referred to as "electromagnetic conducting or absorbing fiber napping section") of a structure in which the fiber stands up from the surface on which the fiber is formed; and an electromagnetic conducting or absorbing fiber convex structure section of a structure in which a mass of the fiber is provided on the surface on which the fiber is formed. Concretely, in the case where the electromagnetic conducting or absorbing fiber convex structure section is formed on the surface of the pressure-sensitive adhesive or adhesive layer or substrate, examples thereof include an electromagnetic conducting or absorbing fiber napping section having a structure in which the fiber stands up from the surface of the pressure-sensitive adhesive or adhesive layer or substrate; and an electromagnetic conducting or absorbing fiber convex structure section of a structure in which a mass of the fiber is provided on the surface of the pressure-sensitive adhesive or adhesive layer or substrate. Furthermore, in the case where the electromagnetic conducting or absorbing fiber convex structure section is formed on the wall surface of a concave in the pressure-sensitive adhesive or adhesive layer or substrate, examples thereof include an electromagnetic conducting or absorbing fiber napping section having a structure in which at least a part of the fiber stands up from the wall surface of a concave of the pressure-sensitive adhesive or adhesive layer or substrate and stands up protruded outward from the surface of the pressure-sensitive adhesive or adhesive layer or substrate (in particular, the end of the fiber is protruded); and an electromagnetic conducting or absorbing fiber convex structure section having a structure in which a mass of the fiber is provided on the wall surface of a concave of the pressure-sensitive adhesive or adhesive layer or substrate and a part of the fiber is protruded outward from the surface of the pressure-sensitive adhesive or adhesive layer or substrate. The electromagnetic conducting or absorbing fiber convex structure section may be constructed of a single structure or a structure of a combination of plural structures.

Incidentally, one electromagnetic conducting or absorbing fiber convex structure section is usually constructed of plural fibers. The number and density of fibers which constructs one electromagnetic conducting or absorbing fiber convex structure section are not particularly limited but can be properly selected depending upon the desired electromagnetic conducting or absorbing properties.

As the electromagnetic conducting or absorbing fiber convex structure section, an electromagnetic conducting and absorbing fiber napping section of a structure in which the fiber stands up from the surface on which the fiber is formed (in particular, the electromagnetic conducting and absorbing fiber napping section having a structure in which the fiber stands up from the surface of the pressure-sensitive adhesive or adhesive layer or substrate) is preferable.

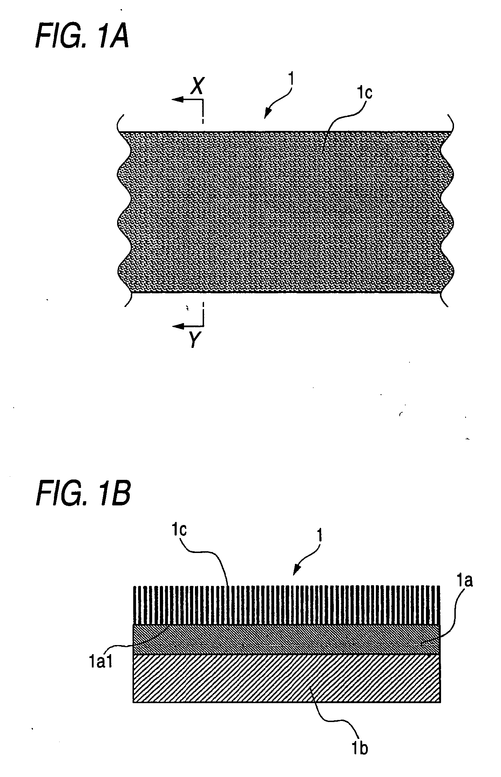

Specific examples of the structure of the invention are shown in Figs. 1A, 1B, 2A, 2B, 3A and 3B. Figs. 1A and 1B each is an outline view to partially show one example of an electromagnetic conducting and absorbing fiber convex section in the structure of the invention; and Fig. 1A is an outline plan view as seen from the upper surface of the structure, while Fig. 1B is an outline cross-sectional view of an X-Y line in Fig. 1A. In Figs. 1A and 1B, 1 stands for a structure; 1a stands for a pressure-sensitive adhesive layer; 1a1 stands for a surface of the pressure-sensitive adhesive layer 1a; 1b stands for an electromagnetic conducting or absorbing base material; and 1c stands for an electromagnetic conducting or absorbing fiber napping section. The structure 1 has a construction in which the pressure-sensitive adhesive layer 1a is formed on one surface of the electromagnetic conducting or absorbing base material 1b and the electromagnetic conducting or absorbing fiber napping section 1c is provided as an electromagnetic conducting or absorbing fiber convex structure section entirely on the surface 1a1 of the subject pressure-sensitive adhesive layer 1a.

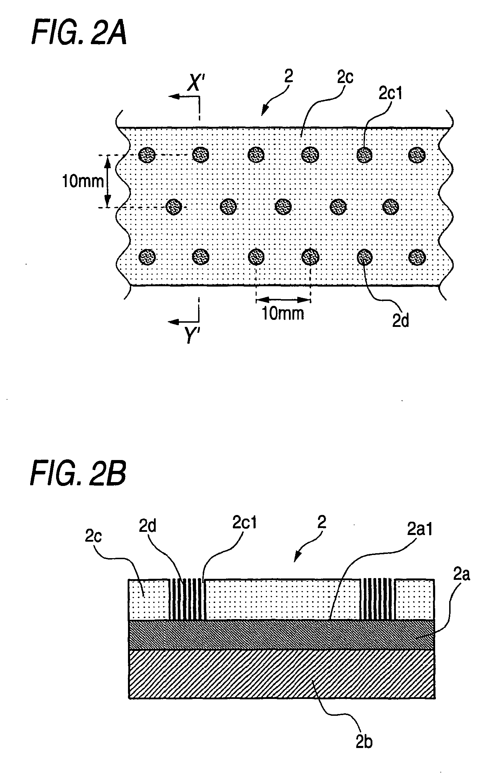

Furthermore, Figs. 2A and 2B each is an outline view to partially show another example of an electromagnetic conducting and absorbing fiber convex section in the structure of the invention; and Fig. 2A is an outline plan view as seen from the upper surface of the structure, while Fig. 2B is an outline cross-sectional view of an X'-Y' line in Fig. 2A. In Figs. 2A and 2B, 2 stands for a structure; 2a stands for a pressure-sensitive adhesive layer; 2a1 stands for a surface of the pressure-sensitive adhesive layer 2a; 2b stands for an electromagnetic conducting or absorbing base material; 2c stands for a release liner; 2c1 stands for a hole section of the release liner 2c; and 2d stands for an electromagnetic conducting or absorbing fiber napping section. The structure 2 has a construction in which the pressure-sensitive adhesive layer 2a is formed on one surface of the electromagnetic conducting or absorbing base material 2b and the pressure-sensitive adhesive layer 2a is protected by the release liner 2c. On the surface 2a1 of the foregoing pressure-sensitive adhesive layer 2a, the electromagnetic conducting or absorbing fiber napping section 2d is provided as an electromagnetic conducting or absorbing fiber convex structure section in a site corresponding to the hole section 2c1 of the release liner 2c. In this structure 2, when the release liner 2c is released, since the surface 2a1 of the pressure-sensitive adhesive layer 2a on which the electromagnetic conducting or absorbing fiber napping section 2d is formed can be partially exposed, sticking can be performed by utilizing the subject pressure-sensitive adhesive surface. Accordingly, the structure 2 as shown in Figs. 2A and 2B can be applied as a pressure-sensitive adhesive tape or sheet having electromagnetic conducting or absorbing properties.

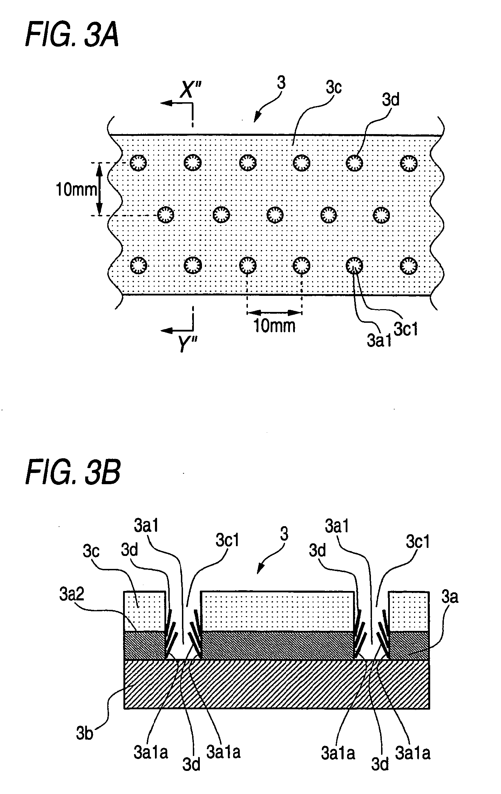

Moreover, Figs. 3A and 3B each is an outline view to partially show a still another example of an electromagnetic conducting and absorbing fiber convex section in the structure of the invention; and Fig. 3A is an outline plan view as seen from the upper surface of the structure, while Fig. 3B is an outline cross-sectional view of an X"-Y" line in Fig. 3A. In Figs. 3A and 3B, 3 stands for a structure; 3a stands for a pressure-sensitive adhesive layer; 3a1 stands for a concave of the pressure-sensitive adhesive layer 3a; 3a1a stands for a wall surface of the concave 3a1 of the pressure-sensitive adhesive layer 3a; 3a2 stands for a surface of the pressure-sensitive adhesive layer 3a; 3b stands for an electromagnetic conducting or absorbing base material; 3c stands for a release liner having a hole section; 3c1 stands for a hole section of the release liner 3c; and 3d stands for an electromagnetic conducting or absorbing fiber napping section. In the structure 3, the pressure-sensitive adhesive or adhesive layer 3a is formed on one surface of the electromagnetic conducting or absorbing base material 3b, and the pressure-sensitive adhesive layer 3a has the concave 3a1 in a form of a through-hole. The subject concave 3a1 is partially formed in the pressure-sensitive adhesive layer 3a. That is, an opening of the concave 3a1 is partially formed on the surface of the pressure-sensitive adhesive layer 3a. Also, this pressure-sensitive adhesive layer 3a has a construction in which its surface 3a2 is protected by the release liner 3c having the hole section 3c1, and the hole section 3c1 of the release liner 3c and the concave 3a1 of the pressure-sensitive adhesive layer 3a have a corresponding positional relation with each other. Concretely, the wall surface of the hole section 3c1 and the wall surface of the concave 3a1 have a continuously formed construction. In addition, the electromagnetic conducting or absorbing fiber napping section 3d is provided as an electromagnetic conducting and absorbing fiber convex structure section on the wall surface 3a1a of the concave 3a1 of the pressure-sensitive adhesive layer 3a. This electromagnetic conducting or absorbing fiber napping section 3d has a structure in which the fiber stands up from the wall surface 3a1a of the concave 3a1 and is protruded outward from the surface 3a2 of the pressure-sensitive adhesive layer 3a (that is, the side of the release liner 3c having the hole section 3c1). In this structure 3, when the release liner 3c is released, since the surface 3a1 of the pressure-sensitive adhesive layer 3a on which the electromagnetic conducting or absorbing fiber napping section 3d is formed can be partially exposed, sticking can be performed by utilizing the subject pressure-sensitive adhesive surface. Accordingly, the structure 3 as shown in Figs. 3A and 3B can be applied as a pressure-sensitive adhesive tape or sheet having electromagnetic conducting or absorbing properties.

In this way, the electromagnetic conducting or absorbing fiber convex structure section (in particular, the electromagnetic conducting and absorbing fiber napping section) may be formed entirely or partially on the surface of the pressure-sensitive adhesive or adhesive layer or substrate. On this occasion, for example, in the case where the electromagnetic conducting or absorbing fiber convex structure section is formed entirely on the surface of the pressure-sensitive adhesive or adhesive layer, since the surface of the pressure-sensitive adhesive or adhesive layer (the surface in the side where the electromagnetic conducting or absorbing fiber convex structure section is formed) is not exposed, the structure can be applied as a structure not having pressure-sensitive adhesive properties or adhesive properties (hereinafter sometimes referred to as "pressure-sensitive adhesive or adhesive properties") (this structure being hereinafter sometimes referred to as "electrically conductive surface non-pressure-sensitive adhesive structure"). Incidentally, in the case where the structure is an electrically conductive surface non-pressure-sensitive adhesive structure (that is, the case where the electromagnetic conducting or absorbing fiber convex structure section is formed entirely on the surface of the pressure-sensitive adhesive or adhesive layer), the surface in the side where the electromagnetic conducting or absorbing fiber convex structure section is not formed may be made so as to serve as a pressure-sensitive adhesive surface or an adhesive surface. In this case, the structure can be applied as an electrically conductive surface non-pressure-sensitive adhesive structure having pressure-sensitive adhesive or adhesive properties in the back surface side [for example, the structure (C) and the structure (A) having a construction in which the pressure-sensitive adhesive layer is formed on the surface of the electromagnetic conducting or absorbing base material (the surface in the side where the electromagnetic conducting or absorbing fiber convex structure section is not formed)].

On the other hand, in the case where the electromagnetic conducting or absorbing fiber convex structure section is formed partially on the surface of the pressure-sensitive adhesive or adhesive layer, since the surface of the pressure-sensitive adhesive or adhesive layer (the surface in the side where the electromagnetic conducting or absorbing fiber convex structure is formed) can be partially exposed, the structure can be applied as a structure having pressure-sensitive adhesive or adhesive properties (hereinafter sometimes referred to as "electrically conductive surface pressure-sensitive adhesive structure"). Incidentally, in Figs. 2A and 2B, the foregoing electromagnetic conducting or absorbing fiber napping section 2d is provided in a shape so as to form plural lines as a whole. In Figs. 3A and 3B, in the foregoing pressure-sensitive adhesive layer 3a, the concave 3a1 is provided in a shape so as to form plural lines as a whole, and therefore, the electromagnetic conducting or absorbing fiber napping section 3d also has a shape so as to form plural lines as a whole. In this way, according to the structure of the invention, the electromagnetic conducting or absorbing convex fiber structure section such as the electromagnetic conducting or absorbing fiber napping section may be provided in a shape so as to form plural lines as a whole.

In the structure 2 according to Figs. 2A and 2B, an interval between the respective lines in the electromagnetic conducting or absorbing fiber napping section 2d (an interval between the centers of the respective lines) is 10 mm, and an interval between the respective electromagnetic conducting or absorbing fiber napping sections to be contained in one line (an interval between the centers of the respective electromagnetic conducting or absorbing fiber napping sections) is 10 mm. Furthermore, the shape on the surface of the pressure-sensitive adhesive layer of one electromagnetic conducting or absorbing fiber napping section is a substantially circular shape having a radius of about 0.5 mm (the area is about 0.8 mm$^2$). Moreover, the adjacent lines to each other are constructed in such a manner that in a site positioned in the center between the respective electromagnetic conducting or absorbing fiber napping sections in one of the lines, the respective electromagnetic conducting or absorbing fiber napping sections in the other line are formed.

Also, in the structure 3 according to Figs. 3A and 3B, an interval between the respective lines in the concave 3a1 (an interval between the centers of the respective line) is 10 mm, and an interval between the respective concaves to be contained in one line (an interval between the centers of the respective concaves) is 10 mm. Furthermore, the shape of an opening on the surface of the pressure-sensitive adhesive layer of one concave is a substantially circular shape having a radius of about 0.5 mm (the area is about 0.8 mm$^2$). Moreover, the adjacent lines to each other are constructed in such a manner that in a site positioned in the center between the respective concaves in one of the lines, the respective concaves in the other line are formed. The electromagnetic conducting or absorbing fiber napping section 3d is formed on the wall surface of such a concave 3a1.

Examples of the structure of such an electromagnetic conducting or absorbing fiber napping section include (1) a structure in which the fiber stands up in a substantially "I" shape and is protruded outward from the surface of the pressure-sensitive adhesive or adhesive layer or substrate in a state that one of the ends of one fiber is adhered and fixed to a prescribed surface of the pressure-sensitive adhesive or adhesive layer or substrate (for example, the surface and the wall surface of the concave), while the other end is not fixed (it becomes free) (the structures as shown in Figs. 1A, 1B, 2A, 2B, 3A and 3B); (2) a structure in which the fiber stands up in a substantially "V" shape and is protruded outward from the surface of the pressure-sensitive adhesive or adhesive layer or substrate in a state that the center of one fiber is adhered to a prescribed surface of the pressure-sensitive adhesive or adhesive layer or substrate (for example, the surface and the wall surface of the concave), while the both ends of the fiber are not fixed (they become free); (3) a structure in which the fiber stands up in a substantially inverse "U" shape and is protruded outward from the surface of the pressure-sensitive adhesive or adhesive layer or substrate in a state that the both ends of one fiber are adhered and fixed to a prescribed surface of the pressure-sensitive adhesive or adhesive layer or substrate (for example, the surface and the wall surface of the concave), while the center of the fiber is not fixed (it becomes free); besides, a structure in which the fiber stands up in a shape such as a substantially "W" shape, a substantially "M" shape, a substantially "N" shape, and a substantially "O" shape from a prescribed surface of the pressure-sensitive adhesive or adhesive layer or substrate (for example, the surface and the wall surface of the concave) and is protruded outward from the surface of the pressure-sensitive adhesive or adhesive layer or substrate; and a combined structure of these structures. As the electromagnetic conducting or absorbing fiber napping section, the foregoing structure (1) (a structure in which the fiber stands up in a substantially "I" shape from a prescribed surface of the pressure-sensitive adhesive or adhesive layer or substrate, such as the surface and the wall surface of the concave, and is protruded outward from the surface of the pressure-sensitive adhesive or adhesive layer or substrate) is suitable.

As a matter of course, the electromagnetic conducting or absorbing fiber napping section may be in a state that the fiber linearly stands up in an "I" shape, from a prescribed surface of the pressure-sensitive adhesive or adhesive layer or substrate (for example, the surface and the wall surface of the concave) and is protruded outward from the surface of the pressure-sensitive adhesive or adhesive layer or substrate or in a state that the fiber stands up as a whole in a state having a jagged form, a wave line form, a loop form, etc. and is protruded outward from the surface of the pressure-sensitive adhesive or adhesive layer or substrate.

In the case where the electromagnetic conducting or absorbing fiber convex structure section is partially formed in the pressure-sensitive adhesive or adhesive layer or substrate, the shape as a whole is not particularly limited, but it may have a prescribed pattern shape. Incidentally, in the case where the electromagnetic conducting or absorbing fiber convex structure section is formed on the wall surface of the concave in the pressure-sensitive adhesive or adhesive layer or substrate, the shape as a whole in the electromagnetic conducting or absorbing fiber convex structure section is corresponding to the shape of the concave as a whole.

In the case where the structure of the invention is applied as a structure having pressure-sensitive adhesive or adhesive properties (electrically conductive surface pressure-sensitive adhesive structure) in which the surface of the pressure-sensitive adhesive or adhesive layer on which the electromagnetic conducting or absorbing fiber convex structure section is formed is made so as to serve as the pressure-sensitive adhesive surface or adhesive surface, as described previously, it is important that the electromagnetic conducting or absorbing fiber convex structure section is partially formed in the pressure-sensitive adhesive or adhesive layer. In such case, it is preferable that the electromagnetic conducting or absorbing fiber convex structure section is partially formed in a pattern shape in the pressure-sensitive adhesive or adhesive layer. For example, in the case where the electromagnetic conducting or absorbing fiber convex structure section is formed in a pattern shape as shown in Figs. 2A and 2B as a whole, that is, in the case where the electromagnetic conducting or absorbing fiber convex structure section is formed in a shape so as to form plural lines as a whole, though an interval between the respective lines is not particularly limited, for example, it can be selected within the range of from about 1 to 100 mm (preferably from 3 to 50 mm, and more preferably from 5 to 40 mm) from the viewpoints of pressure-sensitive adhesive properties and adhesive properties and the like. Furthermore, though an interval between the respective electromagnetic conducting or absorbing fiber convex structure sections to be contained in one line is not particularly limited, for example, it can be selected within the range of from about 1 to 100 mm (preferably from 3 to 50 mm, and more preferably from 5 to 40 mm) from the viewpoints of pressure-sensitive adhesive properties and adhesive properties and the like. Moreover, though the positional relation between the respective electromagnetic conducting or absorbing fiber convex structure sections in the adjacent lines to each other is not particularly limited, it may be a positional relation in a lattice form as a whole or a positional relation in an amorphous form as a whole.

Incidentally, in the case where the electromagnetic conducting or absorbing fiber convex structure section is partially formed in the pressure-sensitive adhesive or adhesive layer (that is, in the case where the structure is an electrically conductive surface pressure-sensitive adhesive structure), with respect to one electromagnetic conducting or absorbing fiber convex structure section, though the shape in the surface of the pressure-sensitive adhesive or adhesive layer is not particularly limited, for example, it may be a substantially circular shape, a substantially polygonal shape, or an amorphous shape. Also, the number of electromagnetic conducting or absorbing fiber convex structure sections to be formed in the pressure-sensitive adhesive or adhesive layer is not particularly limited.

Furthermore, in the case where the electromagnetic conducting or absorbing fiber convex structure section is partially formed in the pressure-sensitive adhesive or adhesive layer (that is, in the case where the structure is an electrically conductive surface pressure-sensitive adhesive structure), in the surface of the pressure-sensitive adhesive or adhesive layer, though the whole area of a site in which the electromagnetic conducting or absorbing fiber convex structure section is provided (area of the whole electromagnetic conducting or absorbing fiber convex structure section) is not particularly limited, for example, an area in a proportion of from 0.001 to 20 % (preferably from 0.005 to 15 %, and more preferably from 0.01 to 10 %) based on the whole surface area of the pressure-sensitive adhesive or adhesive layer is desired from the viewpoints of pressure-sensitive adhesive properties and adhesive properties and the like. When the area in the surface of the pressure-sensitive adhesive or adhesive layer of the whole electromagnetic conducting or absorbing fiber convex structure section is less than 0.001 % based on the whole surface area of the pressure-sensitive adhesive or adhesive layer, the electromagnetic conducting or absorbing properties are lowered, and therefor, such is not desired. On the other hand, when the area in the surface of the pressure-sensitive adhesive or adhesive layer of the whole electromagnetic conducting or absorbing fiber convex structure section exceeds 20 % based on the whole surface area of the pressure-sensitive adhesive or adhesive layer, an adhesive strength to an adherend of the structure (that is, the electrically conductive surface adhesive structure) is lowered, and therefore, such is not desired.

In addition, in the case where the structure is an electrically conductive surface adhesive structure, an area in the surface of the pressure-sensitive adhesive or adhesive layer of the respective electromagnetic conducting or absorbing fiber convex structure section is not particularly limited. For example, though it is desired to select the subject area within the range of from about 0.1 to 10 mm$^2$ (preferably from 0.3 to 5 mm$^2$, and more preferably from 0.5 to 3 mm$^2$), the area may be less than 0.1 mm$^2$ or may exceed 10 mm$^2$.

In addition, in the case where plural electromagnetic conducting or absorbing fiber convex structure sections are provided such that the area in the surface of the pressure-sensitive adhesive or adhesive layer of the respective electromagnetic conducting or absorbing fiber convex structure section is from 0.1 to 10 mm$^2$, the shortest interval between the respective electromagnetic conducting or absorbing fiber convex structure sections may be, for example, from about 1 to 100 mm (preferably from 3 to 50 mm, and more preferably from 5 to 40 mm).

Incidentally, as the area in the surface of the pressure-sensitive adhesive or adhesive layer of the electromagnetic conducting or absorbing fiber convex structure section, an area of a portion surrounded by the electromagnetic conducting or absorbing fiber convex structure section can be employed. Accordingly, in the case where the electromagnetic conducting or absorbing fiber convex structure section is formed on the wall surface of the concave of the pressure-sensitive adhesive or adhesive layer, the area in the surface of the pressure-sensitive adhesive or adhesive layer of the electromagnetic conducting or absorbing fiber convex structure section is corresponding to an area of an opening in the surface of the pressure-sensitive adhesive or adhesive layer of the concave.

Such an electromagnetic conducting or absorbing fiber convex structure section can be constructed of a fiber having electromagnetic conducting or absorbing properties (hereinafter sometimes referred to as "electromagnetic conducting or absorbing fiber"). Though the electromagnetic conducting or absorbing fiber is not particularly limited, it may be a fiber in which a fiber raw material itself has electromagnetic conducting or absorbing properties (hereinafter sometimes referred to as "electromagnetic conducting or absorbing raw material fiber") or may be a fiber in which electromagnetic conducting or absorbing properties are imparted to a fiber raw material by an electromagnetic conducting or absorbing material (hereinafter sometimes referred to as "electromagnetic conducting or absorbing properties-imparted fiber"). The electromagnetic conducting or absorbing fiber may be used singly or in combination of two or more kinds thereof.

Incidentally, as the fiber which constructs the electromagnetic conducting or absorbing fiber convex structure section, a fiber not having electromagnetic conducting or absorbing properties (hereinafter sometimes referred to as "non-electromagnetic conducting or absorbing fiber") may be used together with the electromagnetic conducting or absorbing fiber. In this way, in the case where the non-electromagnetic conducting or absorbing fiber is used together with the electromagnetic conducting or absorbing fiber, the electromagnetic conducting or absorbing fiber and the non-electromagnetic conducting or absorbing fiber may be used as a separate yarn from each other or may be used as a single yarn. That is, the electromagnetic conducting or absorbing fiber convex structure section may be constructed of a yarn composed of only the electromagnetic conducting or absorbing fiber and a yarn composed of only the non-electromagnetic conducting or absorbing fiber or may be constructed of a twisted yarn of the electromagnetic conducting or absorbing fiber and the non-electromagnetic conducting or absorbing fiber. Examples of the non-electromagnetic conducting or absorbing fiber include a cotton fiber, a rayon fiber, a polyamide-based fiber, a polyester-based fiber, a polyacrylonitrile-based fiber, an acrylic fiber, a polyvinyl alcohol fiber, a polyethylene-based fiber, a polyimide-based fiber, a polyolefin-based fiber, a silicone-based fiber, and a fluorine-based resin fiber.

In the electromagnetic conducting or absorbing fiber, a fiber constructed of a material in which the fiber raw material itself has electromagnetic conducting or absorbing properties can be used as the electromagnetic conducting or absorbing raw material fiber. Examples of the electromagnetic conducting or absorbing raw material fiber include a metallic fiber in addition to a carbon-based fiber and a fiber made of an electrically conductive polymer. Incidentally, examples of the carbon-based fiber include a fiber made of a carbon-based raw material such as carbon black. Furthermore, the electrically conductive polymer in the fiber made of an electrically conductive polymer is not particularly limited, but examples thereof include a polyacetylene-based electrically conductive polymer, a polypyrrole-based electrically conductive polymer, a polyacene-based electrically conductive polymer, a polyphenylene-based electrically conductive polymer, a polyaniline-based electrically conductive polymer, and a polythiophene-based electrically conductive polymer. In addition, though the metallic fiber is not particularly limited, it can be properly selected among fibers made of a metal material as specifically enumerated below. Specific examples of the metallic fiber include fibers made of a metal element (for example, a gold fiber, a silver fiber, an aluminum fiber, an iron fiber, a copper fiber, a nickel fiber, a stainless steel-based fiber, and a copper-nickel alloy fiber) and fibers made of a metallic compound of every kind including metal elements and non-metal elements (for example, a copper sulfide fiber).

Furthermore, in the electromagnetic conducting or absorbing fiber, the electromagnetic conducting or absorbing properties-imparted fiber is not particularly limited so far as it is a fiber in a form that electromagnetic conducting or absorbing properties are imparted by an electromagnetic conducting or absorbing material. Examples thereof include a fiber coated by an electromagnetic conducting or absorbing material (hereinafter sometimes referred to as "electromagnetic conducting or absorbing material-coated fiber"); a fiber having an electromagnetic conducting or absorbing material impregnated therewith (hereinafter sometimes referred to as "electromagnetic conducting or absorbing material-impregnated fiber"); and a fiber containing an electromagnetic conducting or absorbing material in a fiber raw material (hereinafter sometimes referred to as "electromagnetic conducting or absorbing material-containing raw material fiber").

As the electromagnetic conducting or absorbing properties-imparted fiber, the electromagnetic conducting or absorbing material-coated fiber and the electromagnetic conducting or absorbing material-impregnated fiber can be suitably used. In the electromagnetic conducting or absorbing material-coated fiber and the electromagnetic conducting or absorbing material-impregnated fiber as the electromagnetic conducting or absorbing properties-imparted fiber, a fiber (fiber raw material) before the electromagnetic conducting or absorbing properties are imparted by the electromagnetic conducting or absorbing material is not particularly limited, and any of a natural fiber, a semi-synthetic fiber, and a synthetic fiber may be employed. Furthermore, the fiber raw material (fiber) may be an electromagnetic conducting or absorbing fiber or may be a non-electromagnetic conducting or absorbing fiber. More concretely, examples of the fiber raw material (fiber) include a non-electromagnetic conducting or absorbing fiber such as a cotton fiber, a rayon fiber, a polyamide-based fiber [for example, an aliphatic polyamide fiber and an aromatic polyamide fiber (so-called aramid fiber)], a polyester-based fiber (for example, a trade name "TETRON"), a polyacrylonitrile-based fiber, an acrylic fiber, a polyvinyl alcohol fiber (so-called vinylon fiber), a polyethylene-based fiber, a polyimide-based fiber, a polyolefin-based fiber, a silicone-based fiber, and a fluorine-based resin fiber; and an electromagnetic conducting or absorbing fiber such as a carbon fiber (carbon-based fiber). As the fiber raw material, a nonmagnetic conducting or absorbing fiber is preferable; and a cotton fiber, a rayon fiber, a polyamide-based fiber, and a polyester-based fiber are especially preferable. The fiber raw material may be used singly or in combination of two or more kinds thereof.

Moreover, in the electromagnetic conducting or absorbing material-coated fiber as the electromagnetic conducting or absorbing properties-imparted fiber, the electromagnetic conducting or absorbing material is not particularly limited. For example, in addition to a metal material and a plastic material having electromagnetic conducting or absorbing properties (hereinafter sometimes referred to as "electromagnetic conducting or absorbing plastic material"), a magnetic material of every kind can be used. Of these, a metal material can be suitably used. The electromagnetic conducting or absorbing material can be used singly or in combination of two or more kinds thereof. In the electromagnetic conducting or absorbing material-coated fiber, the metal material may be a metal material composed of only a metal element such as a metal element single body and an alloy or may be a metallic compound of every kind containing a non-metal element together with a metal element. As the metal material, a metal material composed of only a metal element is suitable. Concretely, examples of the metal element in the metal material composed of a metal element single body include an element belong to the Group 1 of the Periodic Table (for example, lithium, sodium, potassium, rubidium, and cesium); an element belonging to the Group 2 of the Periodic Table (for example, magnesium, calcium, strontium, and barium); an element belonging to the Group 3 of the Periodic Table (for example, scandium, yttrium, an lathanoids (for example, lanthanum and cerium), and actinoids (for example, actinium)); an element belonging to the Group 4 of the Periodic Table (for example, titanium, zirconium, and hafnium); an element belonging to the Group 5 of the Periodic Table (for example, vanadium, niobium, and tantalum); an element belonging to the Group 6 of the Periodic Table (for example, chromium, molybdenum, and tungsten); an element belonging to the Group 7 of the Periodic Table (for example, manganese, technetium, rhenium); an element belonging to the Group 8 of the Periodic Table (for example, iron, ruthenium, and osmium); an element belonging to the Group 9 of the Periodic Table (for example, cobalt, rhodium, and iridium); an element belonging to the Group 10 of the Periodic Table (for example, nickel, palladium, and platinum); an element belonging to the Group 11 of the Periodic Table (for example, copper, silver, and gold); an element belonging to the Group 12 of the Periodic Table (for example, zinc, cadmium, and mercury); an element belonging to the Group 13 of the Periodic Table (for example, aluminum, gallium, indium, thallium); an element belonging to the Group 14 of the Periodic Table (for example, tin and lead); and an element belonging to the Group 15 of the Periodic Table (for example, antimony and bismuth). On the other hand, examples of the alloy include stainless steel, a copper-nickel alloy, brass, a nickel-chromium alloy, an iron-nickel alloy, a zinc-nickel alloy, a gold-copper alloy, a tin-lead alloy, a silver-tin-lead alloy, a nickel-chromium-iron alloy, a copper-manganese-nickel alloy, and a nickel-manganese-iron alloy.

Furthermore, the metallic compound of every kind containing a non-metal element together with a metal element is not particularly limited so far as it is a metallic compound containing a metal element or an alloy as enumerated previously and capable of exhibiting electromagnetic conducting or absorbing properties. Examples thereof include a metal sulfide (for example, copper sulfide); a metal oxide (for example, iron oxide, titanium oxide, tin oxide, indium oxide, and cadmium tin oxide); and a metal composite oxide.

Concretely, as the metal material, gold, silver, aluminum, iron, copper, nickel, stainless steel, and a copper-nickel alloy can be suitably used. In particular, gold, silver, aluminum, copper, nickel, and a copper-nickel alloy can be suitably used.

Incidentally, examples of the electromagnetic conducting or absorbing plastic material include an electrically conductive plastic material such as a polyacetylene-based electrically conductive polymer, a polypyrrole-based electrically conductive polymer, a polyacene-based electrically conductive polymer, a polyphenylene-based electrically conductive polymer, a polyaniline-based electrically conductive polymer, and a polythiophene-based electrically conductive polymer.

In addition, the magnetic material is not particularly limited, and examples thereof include a soft magnetic powder, ferrite of every kind, and a zinc oxide whisker. As the magnetic material, a ferromagnetic material exhibiting ferromagnetism or ferrimagnetism is suitable. Specific examples of the magnetic material include high-magnetic permeability ferrite (for example, so-called "soft ferrite" (for example, so-called "Mn ferrite", so-called "Ni ferrite", so-called "Zn ferrite", so-called "Mn-Zn ferrite", and so-called "Ni-Zn ferrite")), pure iron, silicon atom-containing iron (for example, so-called "silicon steel"), a nickel-iron-based alloy (for example, so-called "permalloy" (for example, an nickel-manganese-iron alloy, a nickel-molybdenum-copper-iron alloy, and a nickel-molybdenum-manganese-iron alloy)), an iron-cobalt-based alloy, an amorphous metal high-magnetic permeability material, an iron-aluminum-silicon alloy (for example, so-called "Sendust alloy"), an iron-aluminum-silicon-nickel alloy (for example, so-called "Super Sendust alloy"), so-called "ferrite magnet" (for example, so-called "hard ferrite" (for example, so-called "Ba ferrite" and so-called "Sr ferrite")), so-called "Alnico magnet" (for example, an iron-nickel-aluminum-cobalt alloy), an iron-chromium-cobalt alloy, so-called "rare earth cobalt magnet" (for example, so-called "Sm-Co magnet" and co-called "2-17 type magnet"), so-called "Nd-Fe-B magnet", so-called "rare earth-iron-nitrogen interstitial compound magnet", and so-called "Mn-Al-C magnet".

In the electromagnetic conducting or absorbing material-coated fiber, a method for coating an electromagnetic conducting or absorbing material on a fiber raw material is not particularly limited, but a known coating method can be properly selected and applied depending upon the type of the electromagnetic conducting or absorbing material. For example, in the case where the electromagnetic conducting or absorbing material is a metal material, as a method for forming the electromagnetic conducting or absorbing material-coated fiber, a coating method by vapor deposition of a metal material and a coating method by plating of a metal material are suitable.

Furthermore, in the electromagnetic conducting or absorbing material-impregnated fiber as the electromagnetic conducting or absorbing properties-imparted fiber, an electromagnetic conducting or absorbing material (for example, a metal material, an electromagnetic conducting or absorbing plastic material, and a magnetic material) the same as the electromagnetic conducting or absorbing material in the foregoing electromagnetic conducting or absorbing material-coated fiber can be used as the electromagnetic conducting or absorbing material, and a metal material (in particular, gold, silver, aluminum, copper, nickel, and a copper-nickel alloy) can be suitably used. In the electromagnetic conducting or absorbing material-impregnated fiber, a method for impregnating the fiber raw material with the electromagnetic conducting or absorbing material is not particularly limited, but a known impregnation method can be properly selected and applied depending upon the type of the electromagnetic conducting or absorbing material. For example, in the case where the electromagnetic conducting or absorbing material is a metal material, as a method for forming the electromagnetic conducting or absorbing material-impregnated fiber, an impregnation method for dipping the fiber raw material into the metal material is suitable.

Incidentally, in the electromagnetic conducting or absorbing material-containing raw material fiber as the electromagnetic conducting or absorbing properties-imparted fiber, an electromagnetic conducting or absorbing material (for example, a metal material, an electromagnetic conducting or absorbing plastic material, and a magnetic material) the same as the electromagnetic conducting or absorbing material in the foregoing electromagnetic conducting or absorbing material-coated fiber can be used as the electromagnetic conducting or absorbing material, and a metal material (in particular, gold, silver, aluminum, copper, nickel, and a copper-nickel alloy) can be suitably used. The electromagnetic conducting or absorbing material such as a metal material may have a form of every kind such as a powdery form, a film-like form, a foil-like form, a thin layer-like form, and a fibrous form. Furthermore, as a material of the fiber raw material in the electromagnetic conducting or absorbing material-containing raw material fiber, a plastic material (for example, a polyamide, a polyester, polyacrylonitrile, an acrylic resin, polyvinyl alcohol, polyethylene, a polyimide, a polyolefin-based resin, a silicone-based resin, and a fluorine-based resin) is suitably used. In the electromagnetic conducting or absorbing material-containing raw material fiber, a method for containing the electromagnetic conducting or absorbing material in the fiber raw material is not particularly limited, but a known containing method can be properly selected and applied depending upon the type of the electromagnetic conducting or absorbing material. For example, there is enumerated a method for containing the electromagnetic conducting or absorbing material in the fiber raw material by mixing a material of the fiber raw material with the electromagnetic conducting or absorbing material by means of kneading, etc. and then fibrillating the mixture.

In the invention, as the electromagnetic conducting or absorbing fiber, at least one kind of a fiber selected from an electromagnetic conducting or absorbing material-coated fiber, an electromagnetic conducting or absorbing material-impregnated fiber, and an electromagnetic conducting or absorbing raw material fiber can be suitably used. Accordingly, the electromagnetic conducting or absorbing fiber convex structure section can be suitably constructed of at least one kind of a fiber selected from an electromagnetic conducting or absorbing material-coated fiber, an electromagnetic conducting or absorbing material-impregnated fiber, and an electromagnetic conducting or absorbing raw material fiber.

As such an electromagnetic conducting or absorbing fiber (or fiber raw material), a short fiber can be suitably used. When the length of the electromagnetic conducting or absorbing fiber is long, in the case where the surface on which the electromagnetic conducting or absorbing fiber convex structure section is formed is an electromagnetic conducting or absorbing material having pressure-sensitive adhesive properties (electrically conductive surface pressure-sensitive adhesive structure), the adhesive strength to an adherend is lowered. It is desired that the electromagnetic conducting or absorbing fiber (or fiber raw material) has a length of from about 0.1 to 5 mm (preferably from 0.3 to 5 mm, and more preferably from 0.3 to 2 mm). Incidentally, when the length of the electromagnetic conducting or absorbing fiber is too short, the production is difficult and the costs become high, and therefore, such is not preferable from the viewpoint of cost. On the other hand, when the length of the electromagnetic conducting or absorbing fiber is too long, a rate of recovery of the adhesive strength is lowered in the electrically conductive surface pressure-sensitive adhesive structure, and therefore, such is not desirable.

Furthermore, the thickness of the electromagnetic conducting or absorbing fiber (fiber raw material) is not particularly limited, but for example, it can be selected within the range of from about 0.1 to 20 deniers (preferably from 0.5 to 15 deniers, and more preferably from 1 to 6 deniers). When the thickness of the electromagnetic conducting or absorbing fiber is too thick, for example, in the electrically conductive surface pressure-sensitive adhesive structure, a pressure to be applied in adhering the pressure-sensitive adhesive layer to an adherend becomes high due to a lowering of the flexibility, while when the thickness of the electromagnetic conducting or absorbing fiber is too thin, the handling properties are lowered, and therefore, such is not preferable.

Incidentally, as the electromagnetic conducting or absorbing fiber, plural kinds or two or more kinds of electromagnetic conducting or absorbing fibers or an electromagnetic conducting or absorbing fibers using plural kinds or two or more kinds of electromagnetic conducting or absorbing materials are preferably used. In particular, plural kinds or two or more kinds of electromagnetic conducting or absorbing fibers can be suitably used. In the case where plural kinds or two or more kinds of electromagnetic conducting or absorbing fibers are used as the electromagnetic conducting or absorbing fiber, the plural kinds or two or more kinds of electromagnetic conducting or absorbing fibers may be used as a separate yarn from each other or may be used as a single yarn. That is, the electromagnetic conducting or absorbing fiber convex structure section may be constructed of plural kinds or two or more kinds of yarns composed of plural kinds or two or more kinds of electromagnetic conducting or absorbing fibers or may be constructed of a twisted yarn using plural kinds or two or more kinds of electromagnetic conducting or absorbing fibers. In this way, by using plural kinds or two or more kinds of electromagnetic conducting or absorbing fibers or the like as the electromagnetic conducting or absorbing fiber, it is possible to obtain a structure corresponding to wide electromagnetic waves as described below.

A method for forming the electromagnetic conducting or absorbing fiber convex structure section (in particular, the electromagnetic conducting or absorbing fiber napping section) is not particularly limited, but a flocking processing method (in particular, an electrostatic flocking processing method) can be suitably applied as described below. As the foregoing electrostatic flocking processing method, all of an up method, a down method and a side method may be employed. Incidentally, in forming the electromagnetic conducting or absorbing fiber convex structure section in a prescribed site on the surface of the pressure-sensitive adhesive or adhesive layer by the flocking processing method, it is preferred to use a release base material (in particular, a release film) having a hole section in the position corresponding to a prescribed site on the surface of the pressure-sensitive adhesive or adhesive layer in which the electromagnetic conducting or absorbing fiber convex structure section is to be formed. Furthermore, in forming the electromagnetic conducting or absorbing fiber convex structure section on the wall surface of the concave of the pressure-sensitive adhesive or adhesive layer by the flocking processing method, it is preferred to use a release base material (in particular, a release film) having a hole section in the position corresponding to the concave of the pressure-sensitive adhesive or adhesive layer (the concave in which the electromagnetic conducting or absorbing fiber convex structure section is to be formed). Such a release base material can also be applied as a release liner.

(Pressure-sensitive adhesive or adhesive layer)

In the structure (A), a pressure-sensitive adhesive layer or an adhesive layer (pressure-sensitive adhesive or adhesive layer) is used. Furthermore, in the structures (B) and (D), a pressure-sensitive adhesive or adhesive layer can be used as the substrate. Moreover, in the structure (C), a pressure-sensitive adhesive layer is used. In such a pressure-sensitive adhesive or adhesive layer, the pressure-sensitive adhesive which constructs the pressure-sensitive adhesive layer is not particularly limited, and useful examples thereof include a known pressure-sensitive adhesive such as a rubber-based pressure-sensitive adhesive, an acrylic pressure-sensitive adhesive, a polyester-based pressure-sensitive adhesive, a urethane-based pressure-sensitive adhesive, a polyamide-based pressure-sensitive adhesive, an epoxy-based pressure-sensitive adhesive, a vinyl alkyl ether-based pressure-sensitive adhesive, a silicone-based pressure-sensitive adhesive, and a fluorine-based pressure-sensitive adhesive. Furthermore, the pressure-sensitive adhesive may be a hot melt type pressure-sensitive adhesive. On the other hand, the adhesive which constructs the adhesive layer is not particularly limited, and useful examples thereof include a known adhesive such as a rubber-based adhesive, an acrylic adhesive, a polyester-based adhesive, a urethane-based adhesive, a polyamide-based adhesive, an epoxy-based adhesive, a vinyl alkyl ether-based adhesive, a silicone-based adhesive, and a fluorine-based adhesive. Moreover, the adhesive may be a heat-sensitive adhesive. The pressure-sensitive adhesive or adhesive can be used singly or in combination of two or more kinds thereof. The pressure-sensitive adhesive or adhesive may be a pressure-sensitive adhesive or adhesive of any form such as an emulsion-based form, a solvent-based form, an oligomer-based form, and a solid-based form.

Incidentally, the pressure-sensitive adhesive or adhesive may contain, in addition to a polymer component (base polymer) such as a pressure-sensitive adhesive component or adhesive component, appropriate additives such as a crosslinking agent (for example, a polyisocyanate-based crosslinking agent and an alkyl etherified melamine compound-based crosslinking agent), a tackifier (for example, a rosin derivative resin, a polyterpene resin, a petroleum resin, and a phenol resin), a plasticizer, a filler, and an antiaging agent depending upon the type of the pressure-sensitive adhesive or adhesive and the like. In the case of performing crosslinking in forming the pressure-sensitive adhesive layer or adhesive layer, a known crosslinking method such as a heat crosslinking method by heating, an ultraviolet ray crosslinking method by irradiation with ultraviolet rays (UV crosslinking method), an electron beam crosslinking method by irradiation with electron beams (EB crosslinking method), and a spontaneous curing method for achieving spontaneous curing at room temperature, etc. can be applied.

In the invention, a pressure-sensitive adhesive layer is suitable as the pressure-sensitive adhesive or adhesive layer. As the pressure-sensitive adhesive which constitutes the pressure-sensitive adhesive layer, a rubber-based pressure-sensitive adhesive and an acrylic pressure-sensitive adhesive can be suitably used.

In the invention, when the pressure-sensitive adhesive or adhesive layer is formed of an electromagnetic conducting or absorbing material-containing pressure-sensitive adhesive composition or adhesive composition, the electromagnetic conducting or absorbing properties can be much more enhanced. That is, it is preferable that the pressure-sensitive adhesive or adhesive layer has electromagnetic conducting or absorbing properties. The electromagnetic conducting or absorbing material to be contained in such a pressure-sensitive adhesive composition or adhesive composition is not particularly limited. For example, one or two or more kinds of electromagnetic conducting or absorbing materials such as a metal material, an electromagnetic conducting or absorbing plastic material (for example, an electrically conductive plastic material), and a magnetic material can be used. Of these, a metal material can be suitably used. Incidentally, examples of the metal material, the electromagnetic conducting or absorbing plastic material, and the magnetic material include a metal material, an electromagnetic conducting or absorbing plastic material, and a magnetic material as enumerated in the foregoing electromagnetic conducting or absorbing fiber which constructs the electromagnetic conducting or absorbing fiber convex structure section. The electromagnetic conducting or absorbing material such as a metal material, an electromagnetic conducting or absorbing plastic material, and a magnetic material may have any form such as a powdery form, a film-like form, a foil-like form, and a thin layer-like form.

The electromagnetic conducting or absorbing material-containing pressure-sensitive adhesive composition or adhesive composition can be prepared by mixing a pressure-sensitive adhesive or an adhesive with an electromagnetic conducting or absorbing material. Incidentally, the content proportion of the electromagnetic conducting or absorbing material is not particularly limited but can be properly selected depending upon the pressure-sensitive adhesive properties or adhesive properties of the pressure-sensitive adhesive or the adhesive, the electromagnetic conducting or absorbing properties of the pressure-sensitive adhesive or adhesive layer, and the like. For example, it is preferable that the content proportion of the electromagnetic conducting or absorbing material is from 3 to 98 % by weight (in particular, from 5 to 95 % by weight) of the total amount of solids in the pressure-sensitive adhesive composition or adhesive composition. When the content proportion of the electromagnetic conducting or absorbing material is too small, the electromagnetic conducting or absorbing properties of the pressure-sensitive adhesive or adhesive layer is lowered, while when it is too large, the pressure-sensitive adhesive properties or adhesive properties of the pressure-sensitive adhesive or adhesive layer is lowered.

The pressure-sensitive adhesive or adhesive layer may have any form of a single-layered form or a laminated form.

As a method for forming the pressure-sensitive adhesive or adhesive layer, a known method for forming a pressure-sensitive adhesive layer or a known method for forming an adhesive layer (for example, a coating forming method and a transfer forming method) can be employed. The forming method can be properly selected depending upon the type, shape and size of the structure or support and the like. Concretely, for example, in the case where the pressure-sensitive adhesive layer is formed on the electromagnetic conducting or absorbing base material as in the structure (A), examples of the method for forming a pressure-sensitive adhesive layer include a method for coating a pressure-sensitive adhesive on the electromagnetic conducting or absorbing base material (coating method); and a method for coating a pressure-sensitive adhesive on a release film such as a release liner to form a pressure-sensitive adhesive layer and then transferring the subject pressure-sensitive adhesive layer onto the electromagnetic conducting or absorbing base material (transfer method). Furthermore, in the case where the pressure-sensitive adhesive layer is formed on the release liner as in the structure (C), examples of the method for forming a pressure-sensitive adhesive layer include a method for coating a pressure-sensitive adhesive on the release surface of the release liner (coating method). Incidentally, in the structure (A) and the like, an adhesive layer can be used as the pressure-sensitive adhesive or adhesive layer. In this case, examples of the method for forming an adhesive layer include a method for coating an adhesive on a prescribed surface of the electromagnetic conducting or absorbing base material (coating method).

The thickness of the pressure-sensitive adhesive or adhesive layer is not particularly limited. For example, it can be selected within the range of from about 1 to 1,000 $\mu$m (preferably from 10 to 500 $\mu$m).

Incidentally, in the pressure-sensitive adhesive or adhesive (in particular, the pressure-sensitive adhesive layer), a concave may be partially formed. Though such a concave may be a depressed section, it is preferably a hole section (through-hole section). In the hole section, a perforated section is especially suitable. In such a concave, it is possible to adapt the shape as the whole of the concave, the shape of an opening in the surface of the pressure-sensitive adhesive or adhesive layer of the respective concave, the whole area of an opening in the surface of the pressure-sensitive adhesive or adhesive layer of the respective concave, the area of an opening in the surface of the pressure-sensitive adhesive or adhesive layer of the respective concave, and the like with the foregoing electromagnetic conducting or absorbing fiber convex structure section. Incidentally, in the case where the concave is a depressed section, its depth is not particularly limited but can be properly selected within the range of a depth corresponding to 1 % or more (for example, from 1 to 99 %, and preferably from 30 to 90 %) of the thickness of the pressure-sensitive adhesive or adhesive layer.

Furthermore, in the structure (C) and the like, the pressure-sensitive adhesive layer can be formed on the release liner. In this case, a depressed section as the concave can be formed on at least one surface of the pressure-sensitive adhesive layer, and preferably on one surface of the pressure-sensitive adhesive layer. Moreover, in the structure (A) and the like, the pressure-sensitive adhesive layer can be formed on each of the both surfaces of the electromagnetic conducting or absorbing base material. In this case, the concave (for example, a depressed section and a hole section) can be formed on at least one surface of the pressure-sensitive adhesive layer, and preferably on one surface of the pressure-sensitive adhesive layer.

In the case where the concave is a hole section, examples of a method for forming a hole section include a perforating processing method using a known and/or usual hole section forming machine [above all, a perforation forming machine having a convex structure of a shape of every kind (protruded structure) and a concave structure counterpart to the subject convex structure], a perforation processing method by heat or beams (for example, a method for performing perforation by a thermal head, a halogen vapor lamp, a xenon lamp, a flash lamp, a laser beam, etc.), and a molding method using a mold (for example, a mold having a convex). Incidentally, in the case where the concave is a depressed section, as a method for forming a depressed section, a forming method the same as the method for forming a hole section can be employed.

Incidentally, in the case where the pressure-sensitive adhesive or adhesive layer is a pressure-sensitive adhesive layer and in forming the electromagnetic conducting or absorbing fiber convex structure section in the concave of the pressure-sensitive adhesive layer, a release base material (in particular, a release film) having a hole section in a position corresponding to a prescribed site on the surface of the pressure-sensitive adhesive layer in which the electromagnetic conducting or absorbing fiber convex structure section is to be formed is used, it is preferred to form the concave of the pressure-sensitive adhesive layer together with the foregoing hole section of the foregoing release base material. For example, by superimposing and laminating a release base material not having a hole section on the surface of the pressure-sensitive adhesive layer having no concave formed therein and performing punching processing such as perforation from the side of the release base material by using a hole section forming machine, etc., it is possible to prepare the concave of the pressure-sensitive adhesive layer (in particular, the hole section by perforation) and the hole section of the release base material at the same time. In the punching processing for forming a hole section as the concave of the pressure-sensitive adhesive layer, in the case where the both surfaces of the pressure-sensitive adhesive layer are each protected by a release liner, though the whole of layers of release liner/pressure-sensitive adhesive layer/ release liner may be subjected to punching processing, it is preferable that only either one release liner is subjected to punching processing of a half-cut type such that no notch line is formed.

(Substrate)

In the structures (B) and (D), a substrate is used. The subject substrate is not particularly limited so far as it can ensure fluidity or pressure-sensitive adhesive or adhesive properties in forming the electromagnetic conducting or absorbing fiber convex structure section. In the invention, a pressure-sensitive adhesive or adhesive layer or a polymer layer is suitably used as the substrate. The pressure-sensitive adhesive layer is the same as described previously. On the other hand, a polymer component for constructing the polymer layer is not particularly limited, but one or two or more kinds of a known polymer component (for example, a resin component (for example, a thermoplastic resin, a thermosetting resin, and an ultraviolet ray-curable resin), a rubber component, and an elastomer component) can be properly selected and used. Concretely, in the polymer component which constructs the polymer layer, examples of the resin component include an acrylic resin, a styrene-based resin, a polyester-based resin, a polyolefin-based resin, a polyvinyl chloride resin, a vinyl acetate-based resin, a polyamide-based resin, a polyimide-based resin, a urethane-based resin, an epoxy-based resin, a fluorine-based resin, a silicone-based resin, polyvinyl alcohol, a polycarbonate, polyacetal, a polyetherimide, polyamide-imide, polyesterimide, polyphenylene ether, polyphenylene sulfide, polyethersulfone, polyetheretherketone, polyetherketone, a polyallylate, polyaryl, and polysulfone. Furthermore, examples of the rubber component include a natural rubber and a synthetic rubber (for example, polyisobutylene, polyisoprene, a chloroprene rubber, a butyl rubber, and a nitrile butyl rubber). Moreover, examples of the elastomer component include a variety of thermoplastic elastomers such as an olefin-based thermoplastic elastomer, a styrene-based thermoplastic elastomer, a polyester-based thermoplastic elastomer, a polyamide-based thermoplastic elastomer, a polyurethane-based thermoplastic elastomer, and an acrylic thermoplastic elastomer.

The substrate may have any form of a single-layered form or a laminated form.

Incidentally, in the substrate, the concave as illustrated in the foregoing paragraph of the pressure-sensitive adhesive or adhesive layer may be partially formed. The concave to be formed in the substrate is the same as described previously.

In the invention, it is preferable that the substrate has electromagnetic conducting or absorbing properties from the viewpoint of much more improving the electromagnetic conducting or absorbing properties of the structure. The substrate having electromagnetic conducting or absorbing properties can be formed of a composition containing an electromagnetic conducting or absorbing material (for example, a pressure-sensitive adhesive composition, an adhesive composition, and a polymer composition). The electromagnetic conducting or absorbing material which is used in the substrate is not particularly limited. For example, one or two or more kinds of an electromagnetic conducting or absorbing material such as a metal material, an electromagnetic conducting or absorbing plastic material (for example, an electrically conductive plastic material), and a magnetic material can be used. Incidentally, examples of the metal material, the electromagnetic conducting or absorbing material and the magnetic material include the above-enumerated metal material, electromagnetic conducting or absorbing material and magnetic material (for example, an electromagnetic conducting or absorbing fiber which constructs the foregoing electromagnetic conducting or absorbing fiber convex structure section, and a metal material, an electromagnetic conducting or absorbing plastic material, and a magnetic material as enumerated in the foregoing pressure-sensitive adhesive composition or adhesive composition which constructs the pressure-sensitive adhesive or adhesive layer).

(Electromagnetic conducting or absorbing base material)

In the structure (A), an electromagnetic conducting or absorbing base material is used. Furthermore, in the structures (B) and (D), a substrate can be formed on at least one surface of the support (for example, a base material or release liner of every kind), and an electromagnetic conducting or absorbing base material can be suitably used as a base material as the support. Such an electromagnetic conducting or absorbing base material is not particularly limited so far as it is a base material capable of exhibiting electromagnetic conducting or absorbing properties. Examples thereof include a base material constructed of an electromagnetic conducting or absorbing material and a base material containing an electromagnetic conducting or absorbing material on the surface or inside thereof. The electromagnetic conducting or absorbing base material may have any form of a single-layered form or a laminated form.

In the electromagnetic conducting or absorbing base material, the base material constructed of an electromagnetic conducting or absorbing material is not particularly limited. For example, one or two or more kinds of an electromagnetic conducting or absorbing material such as a metal material, an electromagnetic conducting or absorbing plastic material (for example, an electrically conductive plastic material), and a magnetic material can be used. Incidentally, examples of the metal material, the electromagnetic conducting or absorbing plastic material, and the magnetic material include an electromagnetic conducting or absorbing fiber which constructs the foregoing electromagnetic conducting or absorbing fiber convex structure section, and a metal material, an electromagnetic conducting or absorbing plastic material, and a magnetic material as enumerated in the electromagnetic conducting or absorbing material to be contained in the pressure-sensitive adhesive composition or adhesive composition.

Furthermore, the base material containing an electromagnetic conducting or absorbing material on the surface or inside thereof is not particularly limited so far as it is a base material of every kind in which an electromagnetic conducting or absorbing material is used on the surface or inside thereof. Examples of the base material containing an electromagnetic conducting or absorbing material on the surface thereof include a base material having a layer made of an electromagnetic conducting or absorbing material-containing composition containing an electromagnetic conducting or absorbing material (hereinafter sometimes referred to as "electromagnetic conducting or absorbing material-containing layer") on the surface thereof. In the base material having an electromagnetic conducting or absorbing material-containing layer on the surface thereof, it is only required that the electromagnetic conducting or absorbing material-containing layer is formed on at least one surface of the base material. Furthermore, the thickness of the electromagnetic conducting or absorbing material-containing layer is not particularly limited. For example, it can be properly selected within the range of 0.1 $\mu$m or more (for example, from 0.1 $\mu$m to 1 mm). The electromagnetic conducting or absorbing material-containing layer may be a layer having a thin thickness (for example, a thin film layer having a thickness of from about 0.1 to 30 $\mu$m). Accordingly, the base material having an electromagnetic conducting or absorbing material-containing layer on the surface thereof may be a base material having a construction in which an electromagnetic conducting or absorbing material-containing layer having a thin thickness is formed on a base material not having electromagnetic conducting or absorbing properties (hereinafter sometimes referred to as "non-electromagnetic conducting or absorbing base material") or may be a base material having a construction in which a non-electromagnetic conducting or absorbing base material and an electromagnetic conducting or absorbing material-containing layer are laminated.

In an electromagnetic conducting or absorbing material-containing composition for forming such an electromagnetic conducting or absorbing material-containing layer, the electromagnetic conducting or absorbing material may be contained as the major component or mixing component (subcomponent). The electromagnetic conducting or absorbing material is not particularly limited. Useful examples thereof include a metal material, an electromagnetic conducting or absorbing plastic material (for example, an electrically conducting plastic material), and a magnetic material. Accordingly, the electromagnetic conducting or absorbing material-containing layer may be a metal material layer (for example, a metal foil and a metal plate), an electromagnetic conducting or absorbing plastic material layer (for example, an electromagnetic conducting or absorbing plastic material-made film or sheet), or a magnetic material layer. Incidentally, examples of the metal material for forming the electromagnetic conducting or absorbing material-containing layer include a metal material as enumerated previously in the electromagnetic conducting or absorbing fiber which constructs the electromagnetic conducting or absorbing fiber convex structure section, etc. Furthermore, examples of the electromagnetic conducting or absorbing plastic material include an electromagnetic conducting or absorbing plastic material as enumerated previously in the electromagnetic conducting or absorbing fiber which constructs the electromagnetic conducting or absorbing fiber convex structure section, etc. Moreover, examples of the magnetic material include a magnetic material as enumerated previously in the electromagnetic conducting or absorbing fiber which constructs the electromagnetic conducting or absorbing fiber convex structure section, etc. The electromagnetic conducting or absorbing material can be used singly or in combination of two or more kinds thereof. Incidentally, the electromagnetic conducting or absorbing material such as a metal material, an electromagnetic conducting or absorbing plastic material, and a magnetic may have any form such as a powdery form, a film-like form, a foil-like form, and a thin layer-like form.

Furthermore, the non-electromagnetic conducting or absorbing base material to be coated or laminated by the electromagnetic conducting or absorbing material is not particularly limited so far as it is a base material not having electromagnetic conducting or absorbing properties. Useful examples thereof include a plastic base material not having electromagnetic conducting or absorbing properties (for example, a plastic base material composed of, as a raw material, a resin not having electromagnetic conducting or absorbing properties (for example, a polyolefin-based resin, a polyester-based resin, polyvinyl chloride, a vinyl acetate-based resin, polyphenylene sulfide, an amide-based resin, a polyimide-based resin, and polyetheretherketone)); a paper-based base material not having electromagnetic conducting or absorbing properties (for example, wood-free paper, Japanese paper, kraft paper, glassine paper, synthetic paper, and topcoat paper); and a fibrous base material not having electromagnetic conducting or absorbing properties (for example, a cloth or non-woven fabric not having electromagnetic conducting or absorbing properties). Incidentally, the non-electromagnetic conducting or absorbing base material may have any form of a single-layered form or a laminated form.

Incidentally, in the base material having an electromagnetic conducting or absorbing material-containing layer on the surface thereof, a method for forming an electromagnetic conducting or absorbing material-containing material on the surface of the base material is not particularly limited but can be properly selected and applied from a known method (for example, a metal vapor deposition method, a metal plating method, a lamination method by adhesion, an impregnation method, and a painting method) depending upon the type of the electromagnetic conducting or absorbing material, the thickness of the electromagnetic conducting or absorbing material-containing layer, and the like. For example, in the case where the electromagnetic conducting or absorbing material is a metal material and the electromagnetic conducting or absorbing material-containing layer is an electromagnetic conducting or absorbing material-containing layer having a thin thickness, the electromagnetic conducting or absorbing material-containing layer can be formed on the surface of the base material by applying a coating method by vapor deposition of a metal material, a coating method by plating of a metal material, or the like. Accordingly, the base material having an electromagnetic conducting or absorbing material-containing layer on the surface thereof may be a plastic film or sheet having a metal material vapor deposited on the surface thereof (a metal vapor deposited plastic film or sheet) or a plastic film or sheet having a metal material plated on the surface thereof (a metal plated plastic film or sheet).

On the other hand, examples of the base material containing an electromagnetic conducting or absorbing material in the inside thereof include a base material which is formed of an electromagnetic conducting or absorbing material-containing composition containing an electromagnetic conducting or absorbing material. Such a base material may be a base material in which an electromagnetic conducting or absorbing material is formed as a major material which constructs the base material (hereinafter sometimes referred to as "electromagnetic conductive or absorbing material-based base material") or a base material formed of a mixed material containing a major material which constructs the base material and an electromagnetic conducting or absorbing material (hereinafter sometimes referred to as "electromagnetic conducting or absorbing material-containing base material"). Examples of the electromagnetic conducting or absorbing material-based base material include a metallic base material (for example, a metal foil and a metal plate);

an electromagnetic conducting or absorbing plastic base material (for example, a film or sheet formed of an electromagnetic conducting or absorbing plastic material); a fibrous base material having electromagnetic conducting or absorbing properties (electromagnetic conducting or absorbing fibrous base material) (for example, a woven fabric (for example, a cloth) or non-woven fabric formed of a fiber having electromagnetic conducting or absorbing properties); and a magnetic material-based base material (for example, a magnetic material plate). Examples of a metal material for forming the metallic base material include a metal material as enumerated previously in the electromagnetic conducting or absorbing fiber which constructs the electromagnetic conducting or absorbing fiber convex structure section, etc. Furthermore, examples of an electromagnetic conducting or absorbing plastic material for forming the electromagnetic conducting or absorbing plastic base material include an electromagnetic conducting or absorbing plastic material as enumerated previously in the electromagnetic conducting or absorbing fiber which constructs the electromagnetic conducting or absorbing fiber convex structure section, etc. Moreover, useful examples of a fiber in the electromagnetic conducting or absorbing fibrous base material include an electromagnetic conducting or absorbing fiber (for example, a carbon-based fiber, a fiber made of an electrically conductive polymer, and a metallic fiber) as enumerated previously in the electromagnetic conducting or absorbing fiber which constructs the electromagnetic conducting or absorbing fiber convex structure section, etc. In addition, examples of a magnetic material in the magnetic material-based base material include a magnetic material as enumerated previously in the electromagnetic conducting or absorbing fiber which constructs the electromagnetic conducting or absorbing fiber convex structure section, etc.

Furthermore, in the electromagnetic conducting or absorbing material-containing base material, examples of the major material which constructs the base material include a material not having electromagnetic conducting or absorbing properties (hereinafter sometimes referred to as "non-electromagnetic conducting or absorbing material") such as a plastic material not having electromagnetic conducting or absorbing properties (for example, a resin not having electromagnetic conducting or absorbing properties (for example, a polyolefin-based resin, a polyester-based resin, polyvinyl chloride, a vinyl acetate-based resin, polyphenylene sulfide, an amide-based resin, a polyimide-based resin, and polyetheretherketone); a paper material not having electromagnetic conducting or absorbing properties (for example, a paper material for forming a paper-based base material not having electromagnetic conducting or absorbing properties (for example, wood-free paper, Japanese paper, kraft paper, glassine paper, synthetic paper, and topcoat paper)); and a fiber material not having electromagnetic conducting or absorbing properties (for example, a fiber material for forming a fibrous base material not having electromagnetic conducting or absorbing properties (for example, a cloth or non-woven fabric not having electromagnetic conducting or absorbing properties)). The non-electromagnetic conducting or absorbing material can be used singly or in combination of two or more kinds thereof. Examples of the electromagnetic conducting or absorbing material in the electromagnetic conducting or absorbing material-containing base material include a metal material as enumerated previously in the electromagnetic conducting or absorbing fiber which constructs the electromagnetic conducting or absorbing fiber convex structure section, etc., an electromagnetic conducting or absorbing plastic material as enumerated previously in the electromagnetic conducting or absorbing fiber which constructs the electromagnetic conducting or absorbing fiber convex structure section, etc., and a magnetic material as enumerated previously in the electromagnetic conducting or absorbing fiber which constructs the electromagnetic conducting or absorbing fiber convex structure section, etc.

Incidentally, in the electromagnetic conducting or absorbing material-containing base material, in the case where the major material which constructs the base material is a fiber material not having electromagnetic conducting or absorbing properties, the electromagnetic conducting or absorbing material may be in a form that it is impregnated in the fiber or in a form that it is mixed in the fiber material which constructs the fiber.

In the base material containing an electromagnetic conducting or absorbing material in the inside thereof, a method for containing the electromagnetic conducting or absorbing material in the inside of the base material is not particularly limited. For example, in the case where the base material containing an electromagnetic conducting or absorbing material in the inside thereof is an electromagnetic conducting or absorbing material-based base material, it is possible to form the electromagnetic conducting or absorbing material-based base material by applying a known method for forming a metal foil, a known method for forming a plastic film or sheet, a known method forming a fiber, or the like depending upon the type of the electromagnetic conducting or absorbing material-based base material, etc. Furthermore, in the case where the base material containing an electromagnetic conducting or absorbing material in the inside thereof is an electromagnetic conducting or absorbing material-containing base material, for example, after mixing the major material which constructs the base material with the electromagnetic conducting or absorbing material, the electromagnetic conducting or absorbing material-containing base material can be formed by applying a known method for forming a metal foil, a known method for forming a plastic film or sheet, or the like depending upon the types of the major material which constructs the base material and the electromagnetic conducting or absorbing material, etc.

Such an electromagnetic conducting or absorbing base material may have any shape. Examples of the shape of the electromagnetic conducting or absorbing base material include spherical, columnar, polygonal, polygonal conical, conical, plate-like, and sheet-like shapes. In the invention, it is preferable that the electromagnetic conducting or absorbing base material is in a sheet-like form. In the case where the electromagnetic conducting or absorbing base material is in a sheet-like form, it is possible to apply the structure as a sheet-like structure having a sheet-like form (for example, a base material-provided pressure-sensitive adhesive sheet).

Incidentally, if desired, the electromagnetic conducting or absorbing base material may be blended with a variety of additives such as an inorganic filler (for example, titanium oxide and zinc oxide), an antiaging agent (for example, an amine-based antiaging agent, a quinoline-based antiaging agent, a hydroquinone-based antiaging agent, a phenol-based antiaging agent, a phosphorus-based antiaging agent, and a phosphorous acid ester-based antiaging agent), an antioxidant, an ultraviolet absorber (for example, a salicylic acid derivative, a benzophenone-based ultraviolet absorber, a benzotriazole-based ultraviolet absorber, and a hindered amine-based ultraviolet absorber), a lubricant, a plasticizer, and a coloring agent (for example, a pigment and a dye).

For the purpose of improving adhesion to the pressure-sensitive adhesive or adhesive layer or the like, one or both surfaces of the electromagnetic conducting or absorbing base material may be subjected to an appropriate surface treatment such as a physical treatment (for example, a corona treatment and a plasma treatment) and a chemical treatment (for example, an undercoating treatment).

The thickness of the electromagnetic conducting or absorbing base material is not particularly limited. For example, in the case where the electromagnetic conducting or absorbing base material is in a sheet-like form, the thickness can be selected within the range of from about 10 to 300 $\mu$m, and preferably from about 30 to 200 $\mu$m.

(Support)

In the structures (B) and (D), a substrate can be formed on at least one surface of the support. Such a support is not particularly limited but can be properly selected and used depending upon the type of the structure, etc. The shape of the support may be in any form likewise the foregoing electromagnetic conducting or absorbing base material. Examples of the shape include spherical, columnar, polygonal, polygonal conical, conical, plate-like, and sheet-like shapes. Also, the material of the support is not particularly limited, and any material is employable. Examples of the material include a plastic material, a metal material, a fiber material, and a paper material. Such a material may be used singly or in combination of two or more kinds thereof.

For example, in the case where the structure is a sheet-like structure having a sheet-like form, useful examples of the support include a base material in a sheet-like form (for example, a base material for pressure-sensitive adhesive tape or sheet) and a release liner for pressure-sensitive adhesive tape or sheet. Concretely, for example, in the case where the structure is formed of a pressure-sensitive adhesive tape or sheet of a base material-provided type in which one or both surfaces thereof are a pressure-sensitive adhesive layer, a base material for pressure-sensitive adhesive tape or sheet can be used as the support. Furthermore, for example, in the case where the structure is formed of a double-sided pressure-sensitive adhesive tape or sheet of a base material-less type, a release liner (separator) for pressure-sensitive adhesive tape or sheet can be used as the support. Incidentally, in the case where the structure is formed of a pressure-sensitive adhesive tape or sheet of a base material-provided type in which one or both surfaces thereof are a pressure-sensitive adhesive layer, not only the pressure-sensitive adhesive layer is formed on one or both surfaces of the base material (the base material for pressure-sensitive adhesive tape or sheet) as the support, but also the electromagnetic conducting or absorbing fiber convex structure section is formed on the surface of the pressure-sensitive adhesive layer formed on one or both surfaces of the base material or the wall surface of the concave. Furthermore, if desired, the surface of the subject pressure-sensitive adhesive layer may be protected by the release surface in the back surface side of the base material or the release liner. On the other hand, in the case where the structure is formed of a double-sided pressure-sensitive adhesive tape or sheet of a base material-less type, not only the release liner (release liner for pressure-sensitive adhesive tape or sheet) serves as a support of the pressure-sensitive adhesive layer, but also the electromagnetic conducting or absorbing fiber convex structure section is formed on the surface of the pressure-sensitive adhesive layer or the wall surface of the concave. In this case, in the case where the concave to be formed in the pressure-sensitive adhesive layer is a depressed section, the depressed section as the concave can be formed on the pressure-sensitive adhesive surface of either one of the pressure-sensitive adhesive layers. Incidentally, the release liner as the support not only supports the pressure-sensitive adhesive layer but also protects the surface of the pressure-sensitive adhesive layer until the structure is used.

(Base material)

In the case where the structure is a sheet-like structure (for example, an electrically conductive sheet), a base material in a sheet-like form can be suitably used as the base material which is the support as described previously. As such a base material in a sheet-like form, a base material for pressure-sensitive adhesive tape or sheet (base material) is suitably used. As the base material, an appropriate thin sheet body such as a plastic base material (for example, a plastic film or sheet); a metallic base material (for example, a metal foil and a metal plate); a paper-based base material (for example, paper (for example, wood-free paper, Japanese paper, kraft paper, glassine paper, synthetic paper, and topcoat paper)); a fibrous base material (for example, a cloth, a non-woven fabric, and a net); a rubber-based base material (for example, a rubber sheet); and a foamed body (for example, a foamed sheet) can be used. The base material may have any form of a single-layered form or a laminated form. For example, the base material may be a multilayered body (two-layered or three-layered composite body) of a plastic base material and other base material (for example, a metallic base material, a paper-based base material, and a fibrous base material) by lamination, co-extrusion, or the like.

The base material is preferably a plastic base material such as a plastic film or sheet. Examples of a raw material (plastic material) of such a plastic base material include an olefin-based resin composed of an α-olefin as a monomer component (for example, polyethylene (PE), polypropylene (PP), an ethylene-propylene copolymer, and an ethylene-vinyl acetate copolymer (EVA)); a polyester-based resin (for example, polyethylene terephthalate (PET), polyethylene naphthalate (PEN), and polybutylene terephthalate (PBT)); polyvinyl chloride (PVC); a vinyl acetate-based resin; polyphenylene sulfide (PPS); an amide-based resin (for example, a polyamide (nylon) and a wholly aromatic polyamide (aramid); a polyimide-based resin; and polyetheretherketone (PEEK). Furthermore, in the base material, the plastic material of the plastic base material may be an electromagnetic conducting or absorbing plastic material (for example, an electrically conductive plastic material). Examples of the electrically conductive plastic material include an electrically conductive polymer as enumerated previously in the electromagnetic conductive or absorbing fiber, etc. The plastic material may be used singly or in a mixed state of a combination of two or more kinds thereof. Incidentally, the plastic film or sheet may be of a non-stretched type or a stretched type having been subjected to a uniaxial or biaxial stretching treatment.

Furthermore, examples of the metal material for forming the metallic base material (for example, a metal foil and a metal plate) include a metal material as enumerated previously in the electromagnetic conducting or absorbing fiber, etc. The metal material can be used singly or in combination of two or more kinds thereof.

In the invention, for the purpose of much more enhancing the electromagnetic conducting or absorbing properties of the structure, a base material containing an electromagnetic conducting or absorbing material on the surface or inside thereof can be suitably used as the base material. That is, the support is preferably a base material containing an electromagnetic conducting or absorbing material on the surface or inside thereof. Examples of the base material containing an electromagnetic conducting or absorbing material on the surface or inside thereof include a base material containing an electromagnetic conducting or absorbing material on the surface or inside thereof as enumerated previously as the electromagnetic conducting or absorbing base material.

As the base material, a base material containing a material having a characteristic of conducting or absorbing electromagnetic waves on the surface or inside thereof, a foamed body, and a fibrous base material having a characteristic of conducting or absorbing electromagnetic waves can be suitably used. Incidentally, when a foamed body is used as the base material, it is possible to enhance follow-up properties against an irregular section of the surface of an adherend.

Incidentally, if desired, the base material may be blended with a variety of additives such as an inorganic filler (for example, titanium oxide and zinc oxide), an antiaging agent (for example, an amine-based antiaging agent, a quinoline-based antiaging agent, a hydroquinone-based antiaging agent, a phenol-based antiaging agent, a phosphorus-based antiaging agent, and a phosphorous acid ester-based antiaging agent), an antioxidant, an ultraviolet absorber (for example, a salicylic acid derivative, a benzophenone-based ultraviolet absorber, a benzotriazole-based ultraviolet absorber, and a hindered amine-based ultraviolet absorber), a lubricant, a plasticizer, and a coloring agent (for example, a pigment and a dye). Also, as described previously, the base material may be blended with an electromagnetic conducting or absorbing material.

For the purpose of improving adhesion to the pressure-sensitive adhesive or adhesive layer or the like, one or both surfaces of the base material may be subjected to an appropriate surface treatment such as a physical treatment (for example, a corona treatment and a plasma treatment) and a chemical treatment (for example, an undercoating treatment).

The thickness of the base material is not particularly limited. For example, the thickness can be selected within the range of from about 10 to 300 μm, and preferably from about 30 to 200 μm.

(Release liner)

In the structures (B) and (D), a release liner can be used as the support. Furthermore, in the structure (C), the pressure-sensitive adhesive surface of the pressure-sensitive adhesive layer (the surface in the side where the electromagnetic conducting or absorbing fiber convex structure section is not formed) can be protected by a release liner. Examples of the release liner (for example, a release liner for pressure-sensitive adhesive tape or sheet) include a known low adhesive base material in addition to a base material having a layer which has been subjected to a release treatment with a release treating agent on at least one surface thereof.

As the release liner, for example, a release liner having a release treated layer formed on at least one surface of a base material for release liner is suitable. Examples of the base material for release liner include a plastic base material film (synthetic resin film) of every kind, paper, and a multilayered body (two-layered or three-layered composite body) by laminating or co-extruding these base materials. For example, the release treated layer can be formed by using a release treating agent (for example, a silicone-based release treating agent, a fluorine-based release treating agent, and a long-chain alkyl-based release treating agent) singly or in combination of two or more kinds thereof. The release treated layer can be formed by coating a release treating agent on a prescribed surface (at least one surface) of a base material for release liner and then performing a heating step for drying, a curing reaction, etc.

Incidentally, the thickness of the release liner, the thickness of the base material for release liner, the thickness of the release treated layer, and the like are not particularly limited but can be properly selected depending upon the shape of the electromagnetic conducting or absorbing fiber convex structure section, etc.

In particular, in the case where the release liner is used for the purpose of protecting the surface of the pressure-sensitive adhesive or adhesive layer in the side where at least a part of the fiber of the electromagnetic conducting or absorbing fiber convex structure section is positioned outward from the surface of the pressure-sensitive adhesive or adhesive layer and the electromagnetic conducting or absorbing fiber convex structure section is partially formed in the pressure-sensitive adhesive or adhesive layer, since the electromagnetic conducting or absorbing fiber convex structure section is partially formed or a portion or site where at least a part of the fiber of the electromagnetic conducting or absorbing fiber convex structure section is protruded on the surface of the pressure-sensitive adhesive or adhesive layer, a release liner having a concave (for example, a hole section and a depressed section) corresponding to the site where the fiber is positioned on the surface of the pressure-sensitive adhesive or adhesive layer can be suitably used as the release liner. Above all, a release liner having a hole section (in particular, a perforated section) in a site corresponding to the electromagnetic conducting or absorbing fiber convex structure section on the surface of the pressure-sensitive adhesive or adhesive layer as shown in Figs. 2A and 2B; and a release liner having a hole section (in particular, a perforated section) in a site corresponding to the concave of the pressure-sensitive adhesive or adhesive layer as shown in Figs. 3A and 3B are suitable. As such a release liner having a hole section, for the purpose of protecting the fiber of the electromagnetic conducting or absorbing fiber convex structure section not to be fallen down, it is preferable that the thickness of at least the outer peripheral region of the hole section (in particular, the perforated section) is equal to or more than the height of the fiber of the electromagnetic conducting or absorbing fiber convex structure section which is protruded from the surface of the pressure-sensitive adhesive or adhesive layer.

Examples of a method for forming a concave (in particular, a perforated section) of the release liner include a method of using a known and/or usual concave forming machine [above all, a perforation forming machine having a convex structure of a shape of every kind (protruded structure) and a concave structure counterpart to the subject convex structure], a method by heat or beams (for example, a method for performing perforation by a thermal head, a halogen vapor lamp, a xenon lamp, a flash lamp, a laser beam, etc.), and a method by molding processing using a mold (in particular, a mold having a convex).

(Coating layer)

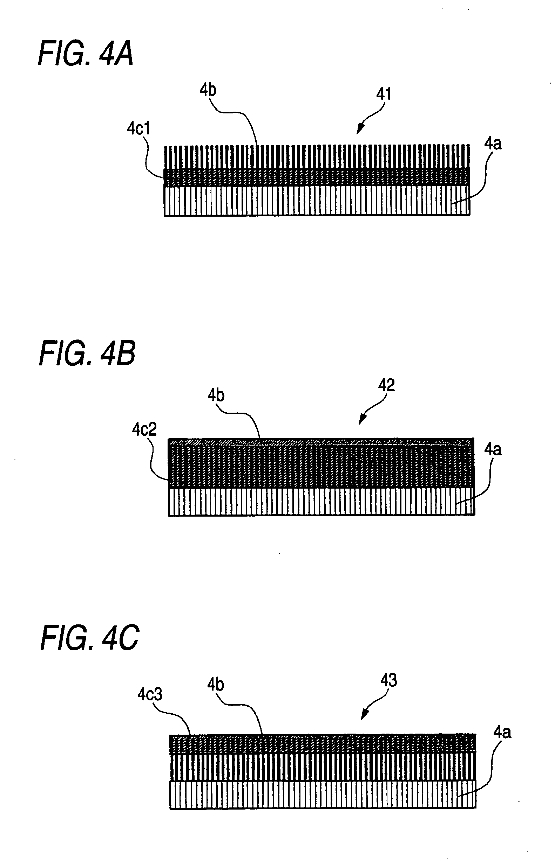

In the structure (B), a coating layer is formed. The coating layer is a layer which coats the electromagnetic conducting or absorbing fiber convex structure section. By the subject coating layer, it is possible to suppress or prevent the fiber which constructs the electromagnetic conducting or absorbing fiber convex structure section from coming out from the substrate, and it is possible to effectively enhance retention of the fiber of the electromagnetic conducting or absorbing fiber convex structure section. Also, by the coating layer, it is possible to enhance characteristics such as impact resistance. Such a coating layer may be a layer which coats at least a part of the fiber in the electromagnetic conducting or absorbing fiber convex structure section. For example, the coating layer can coat each site such as a site in the lower side of the fiber in the electromagnetic conducting or absorbing fiber convex structure section as shown in Fig. 4A; a site of the whole of the fiber in the electromagnetic conducting or absorbing fiber convex structure section as shown in Fig. 4B; and a site in the upper side of the fiber in the electromagnetic conducting or absorbing fiber convex structure section as shown in Fig. 4C.

Figs. 4A, 4B and 4C each is an outline cross-sectional view to show an example of a coating layer in the structure (B). In Figs. 4A, 4B and 4C, 41 to 43 stand for the structure (B), respectively; 4a stands for a substrate; 4b stands for an electromagnetic conducting or absorbing fiber convex structure section; and 4c1 to 4c3 stand for a coating layer, respectively. The structure 41 as shown in Fig. 4A has a construction in which the site in the lower side of the fiber in the electromagnetic conducting or absorbing fiber convex structure section 4b and the surface of the substrate 4a are coated by the coating layer 4c1. Accordingly, the site (at least a tip section) in the upper side of the fiber in the electromagnetic conducting or absorbing fiber convex structure section 4b is positioned outward from the surface (outer surface) of the coating layer 4c1 and exposed outward. Furthermore, the structure 42 as shown in Fig. 4B has a construction in which the whole of the fiber in the electromagnetic conducting or absorbing fiber convex structure section 4b and the surface of the substrate 4a are coated by the coating layer 4c2. Accordingly, the fiber in the electromagnetic conducting or absorbing fiber convex structure section 4b is entirely coated by the coating layer 4c2 but is not exposed outward at all. Moreover, the structure 43 as shown in Fig. 4C has a construction in which the site in the upper side of the fiber in the electromagnetic conducting or absorbing fiber convex structure section 4b is coated by the coating layer 4c3. Accordingly, the site in the lower side (the site in the lower side such as a middle section and a lower section) of the fiber in the electromagnetic conducting or absorbing fiber convex structure section 4b and the surface of the substrate 4a are not coated by the coating layer 4c3.

The coating material which constructs the coating layer is not particularly limited. Examples thereof include a coating material composition containing, as the major component, a known polymer component (for example, a resin component (for example, a thermoplastic resin, a thermosetting resin, and an ultraviolet ray-curable resin), a rubber component, and an elastomer component). Concretely, in the coating material composition which constructs the coating layer, the polymer component can be properly selected and used among a polymer component the same as the polymer component as enumerated previously in the substrate (for example, a resin component (for example, a thermoplastic resin, a thermosetting resin, and an ultraviolet ray-curable resin), a rubber component, and an elastomer component).

The coating layer may have any form of a single-layered form or a laminated formed.

In the invention, it is preferable that the coating layer has electromagnetic conducting or absorbing properties. When the coating layer also has electromagnetic conducting or absorbing properties, it is possible to much more enhance the electromagnetic conducting or absorbing properties of the structure (B). The coating layer having electromagnetic conducting or absorbing properties can be formed of a coating material composition containing an electromagnetic conducting or absorbing material. The electromagnetic conducting or absorbing material which is used in the coating material is not particularly limited. For example, an electromagnetic conducting or absorbing material such as a metal material, an electromagnetic conducting or absorbing plastic material (for example, an electrically conductive plastic material), and a magnetic material can be used singly or in combination of two or more kinds thereof. Incidentally, examples of the metal material, the electromagnetic conducting or absorbing plastic material, and the magnetic material include a metal material, an electromagnetic conducting or absorbing plastic material, and a magnetic material as enumerated previously (for example, a metal material, an electromagnetic conducting or absorbing plastic material, and a magnetic material as enumerated previously in the electromagnetic conducting or absorbing fiber which constructs the electromagnetic conducting or absorbing fiber convex structure section, the pressure-sensitive adhesive composition or adhesive composition which constructs the pressure-sensitive adhesive or adhesive layer, and the composition which constructs the substrate).

The coating material composition containing an electromagnetic conducting or absorbing material can be prepared by mixing a coating material and an electromagnetic conducting or absorbing material. Incidentally, in the coating material composition, the content proportion of the electromagnetic conducting or absorbing material is not particularly limited but can be properly selected depending upon the type of a polymer component of the coating material, the electromagnetic conducting or absorbing properties of the coating layer, and the like. For example, it is preferable that the content proportion of the electromagnetic conducting or absorbing material is from 3 to 98 % by weight (in particular, from 5 to 95 % by weight) of the total amount of solids in the coating material composition. When the content proportion of the electromagnetic conducting or absorbing material is too small, the electromagnetic conducting or absorbing properties of the coating layer is lowered, while when it is too large, the formation of the coating layer becomes difficult.

Incidentally, since the coating layer is a layer for coating the electromagnetic conducting or absorbing fiber convex structure section, it is important that in forming the coating layer, the electromagnetic conducting or absorbing fiber convex structure section be formed in advance in the pressure-sensitive adhesive or adhesive layer or the substrate. Accordingly, after forming the electromagnetic conducting or absorbing fiber convex structure section in the pressure-sensitive adhesive or adhesive layer or the substrate, the coating layer can be formed.

As a method for forming the coating layer, a known forming method (for example, a coating forming method, a dip forming method, and a spray forming method) can be employed. The forming method can be properly selected depending upon the form of the coating layer, the type and form of the electromagnetic conducting or absorbing fiber convex structure section. Concretely, by coating the coating material composition on the electromagnetic conducting or absorbing fiber convex structure section formed in the substrate in a form that at least a part of the fiber is positioned outward from the surface of the substrate, or the subject electromagnetic conducting or absorbing fiber convex structure section and the substrate, the coating layer can be formed.

The thickness of the coating layer is not particularly limited but can be properly set up depending upon the type and form of the coating layer and the length of the fiber which is exposed in the electromagnetic conducting or absorbing fiber convex structure section. In the case where the coating layer does not contain an electromagnetic conducting or absorbing material, from the viewpoint of holding the fiber of the electromagnetic conducting or absorbing fiber convex structure section, it is preferable that the thickness of the coating layer is shorter or thinner than the length of the fiber which is exposed in the electromagnetic conducting or absorbing fiber convex structure section as shown in Fig. 4A. On the other hand, in the case where the coating layer contains an electromagnetic conducting or absorbing material, from the viewpoints of holding the fiber of the electromagnetic conducting or absorbing fiber convex structure section and exhibiting electromagnetic conducting or absorbing properties by the coating layer, the thickness of the coating layer can be properly set up irrespective of the length of the fiber which is exposed in the electromagnetic conducting or absorbing fiber convex structure section. Incidentally, the thickness of the coating layer can be, for example, selected within the range of from 10 to 5,000 μm (preferably from 30 to 3,000 μm, and more preferably from 30 to 2,000 μm).

[Structure (A)]

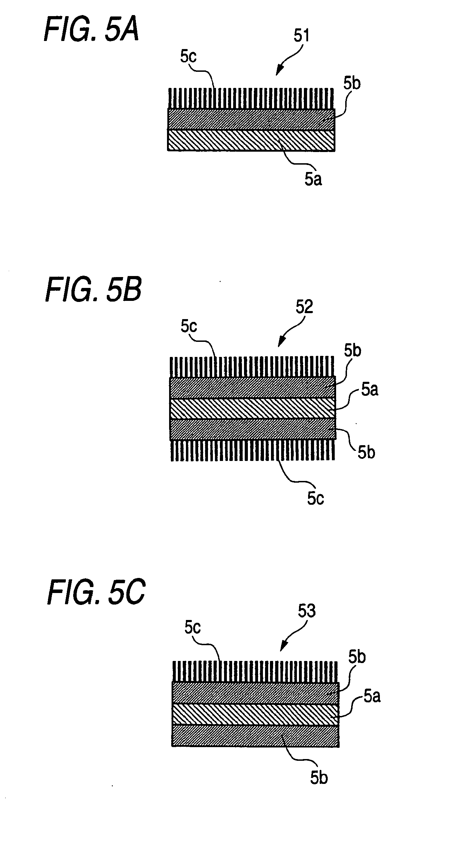

As shown in Figs. 5A, 5B and 5C, the structure (A) of the invention has a construction in which an electromagnetic conducting or absorbing fiber convex structure section is formed in a pressure-sensitive adhesive or adhesive layer formed on at least one surface (both surfaces or one surface) of an electromagnetic conducting or absorbing base material in a form that at least a part of a fiber thereof is positioned outward from the surface of the pressure-sensitive adhesive layer or adhesive layer. Figs. 5A, 5B and 5C each is an outline cross-sectional view to show one example of the structure of the invention. In Figs. 5A, 5B and 5C, 51 to 53 stand for the structure (A), respectively; 5a stands for an electromagnetic conducting or absorbing base material; 5b stands for a pressure-sensitive adhesive or adhesive layer; and 5c stands for an electromagnetic conducting or absorbing fiber convex structure section. The structure (A) 51 as shown in Fig. 5A has a construction in which the electromagnetic conducting or absorbing fiber convex structure section 5c is formed in the pressure-sensitive adhesive or adhesive layer 5b formed on one surface of the electromagnetic conducting or absorbing base material 5a in a form that at least a part of a fiber thereof is positioned outward from the surface of the pressure-sensitive adhesive layer or adhesive layer 5b. The structure (A) 52 as shown in Fig. 5B has a construction in which the electromagnetic conducting or absorbing fiber convex structure sections (5c, 5c) are formed, respectively in the pressure-sensitive adhesive or adhesive layers (5b, 5b) formed on the both surfaces of the electromagnetic conducting or absorbing base material 5a in a form that at least a part of a fiber thereof is positioned outward from the surface of the respective pressure-sensitive adhesive or adhesive layer 5b. The structure (A) 53 as shown in Fig. 5C has a construction in which the electromagnetic conducting or absorbing fiber convex structure section 5c is formed in either one pressure-sensitive adhesive or adhesive layer 5b of the pressure-sensitive adhesive or adhesive layers (5b, 5b) formed on the both surfaces of the electromagnetic conducting or absorbing base material 5a in a form that at least a part of a fiber thereof is positioned outward from the surface of the pressure-sensitive adhesive or adhesive layer 5b.

Incidentally, the pressure-sensitive adhesive or adhesive layers formed on the both surfaces of the electromagnetic conducting or absorbing base material may be the same pressure-sensitive adhesive or adhesive layer each other or a different pressure-sensitive adhesive or adhesive layer from each other. Furthermore, the electromagnetic conducting or absorbing fiber convex structure sections formed on the respective pressure-sensitive adhesive or adhesive layers may be the same electromagnetic conducting or absorbing fiber convex structure section each other or may be a different electromagnetic conducting or absorbing fiber convex structure section from each other. Moreover, the electromagnetic conducting or absorbing fiber convex structure section may be formed entirely on the surface of the pressure-sensitive adhesive or adhesive layer or may be formed partially on the surface of the pressure-sensitive adhesive or adhesive layer.

[Structure (B)]

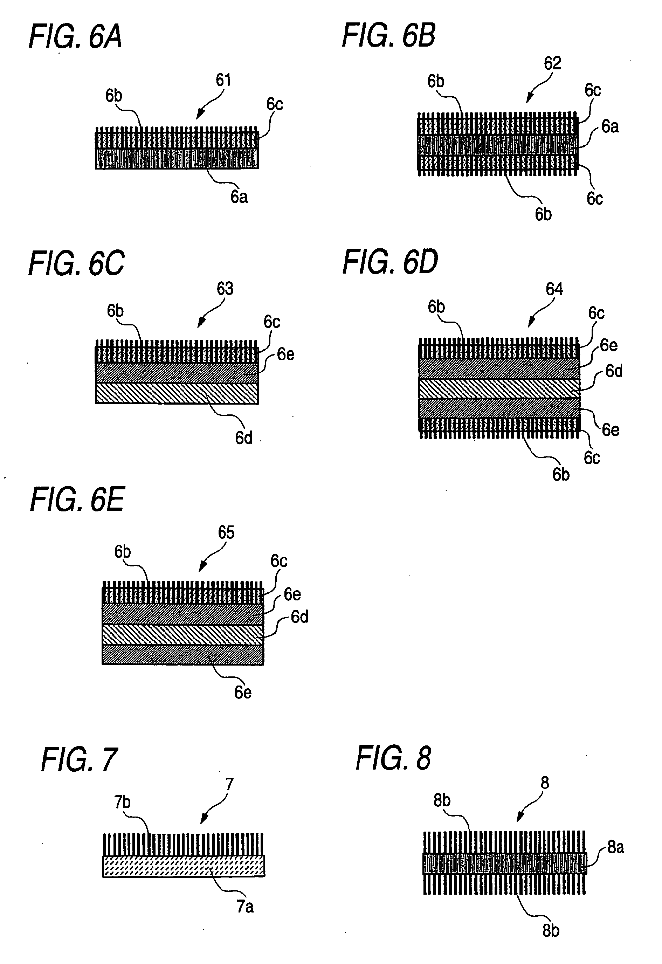

As shown in Figs. 6A, 6B, 6C, 6D and 6E, the structure (B) of the invention has a construction in which an electromagnetic conducting or absorbing fiber convex structure section is formed in a substrate in a form that at least a part of a fiber thereof is positioned outward from the surface of a pressure-sensitive adhesive or adhesive layer and the electromagnetic conducting or absorbing fiber convex structure section formed in the substrate is coated by a coating layer. Figs. 6A, 6B, 6C, 6D and 6E each is an outline cross-sectional view to show an another example of the structure of the invention. In Figs. 6A, 6B, 6C, 6D and 6E, 61 to 65 stands for the structure (B), respectively; 6a stands for a substrate; 6b stands for an electromagnetic conducting or absorbing fiber convex structure section; 6c stands for a coating layer; 6d stands for a base material; and 6e stands for a pressure-sensitive adhesive or adhesive layer. The structure (B) 61 as shown in Fig. 6A has a construction in which the electromagnetic conducting or absorbing fiber convex structure section 6b is formed on one surface of the substrate 6a in a form that at least a part of a fiber thereof is positioned outward from the surface of the substrate 6a and the electromagnetic conducting or absorbing fiber convex structure section 6b is coated by the coating layer 6c. The structure (B) 62 as shown in Fig. 6B has a construction in which the electromagnetic conducting or absorbing fiber convex structure sections (6b, 6b) are formed, respectively on the both surfaces of the substrate 6a in a form that at least a part of a fiber thereof is positioned outward from the respective surface of the substrate 6a and that the electromagnetic conducting or absorbing fiber convex structure sections (6b, 6b) are coated by the coating layers (6c, 6c), respectively.

Furthermore, the structure (B) 63 as shown in Fig. 6C has a form in which the pressure-sensitive adhesive or adhesive layer 6e as a substrate is formed on one surface of the base material 6d; the electromagnetic conducting or absorbing fiber convex structure section 6b is formed in the pressure-sensitive adhesive or adhesive layer 6e formed on one surface of the base material 6d in a form that at least a part of a fiber thereof is positioned outward from the surface of the pressure-sensitive adhesive or adhesive layer 6e; and the electromagnetic conducting or absorbing fiber convex structure section 6b is coated by the coating layer 6c. The structure (B) 64 as shown in Fig. 6D has a form in which the pressure-sensitive adhesive or adhesive layers (6e, 6e) as a substrate are formed on the both surfaces of the base material 6d, respectively; the electromagnetic conducting or absorbing fiber convex structure sections (6b, 6b) are formed on the pressure-sensitive adhesive or adhesive layers (6e, 6e) formed on the both surfaces of the base material 6d, respectively in a form that at least a part of a fiber thereof is positioned outward from the surface of the respective pressure-sensitive adhesive or adhesive layer 6e; and the electromagnetic conducting or absorbing fiber convex structure sections (6b, 6b) are coated by the coating layers (6c, 6c), respectively. The structure (B) 65 as shown in Fig. 6E has a construction in which the pressure-sensitive adhesive or adhesive layers (6e, 6e) as a substrate are formed on the both surfaces of the base material 6d, respectively; the electromagnetic conducting or absorbing fiber convex structure section 6b is formed in either one pressure-sensitive adhesive or adhesive layer 6e of the pressure-sensitive adhesive or adhesive layers (6e, 6e) formed on the both surface of the substrate 6d in a form that at least a part of a fiber thereof is positioned outward from the surface of the pressure-sensitive adhesive or adhesive layer 6e; and the electromagnetic conducting or absorbing fiber convex structure section 6b is coated by the coating layer 6c.

In the light of the above, examples of the structure (B) include a construction in which an electromagnetic conducting or absorbing fiber convex structure section coated by a coating layer is formed on one surface of a substrate; a construction in which an electromagnetic conducting or absorbing fiber convex structure section coated by a coating layer is formed on each of the both surfaces of a substrate; a construction in which an electromagnetic conducting or absorbing fiber convex structure section coated by a coating layer is formed on one surface of a pressure-sensitive adhesive or adhesive layer as a substrate and a base material is formed on the other surface of the foregoing pressure-sensitive adhesive or adhesive layer; a construction in which an electromagnetic conducting or absorbing fiber convex structure section coated by a coating layer is formed on one surface of a pressure-sensitive adhesive or adhesive layer as a substrate, a base material and a pressure-sensitive adhesive or adhesive layer are formed in this order on the other surface of the foregoing pressure-sensitive adhesive or adhesive layer, and an electromagnetic conducting or absorbing fiber convex structure section coated by a coating layer is formed on the surface of the subject pressure-sensitive adhesive or adhesive layer; and a construction in which an electromagnetic conducting or absorbing fiber convex structure section coated by a coating layer is formed on one surface of a pressure-sensitive adhesive or adhesive layer as a substrate and a base material and a pressure-sensitive adhesive or adhesive layer are formed in this order on the other surface of the foregoing pressure-sensitive adhesive or adhesive layer. Accordingly, the structure (B) is corresponding to a structure in which an electromagnetic conducting or absorbing fiber convex structure section is coated by a coating layer in the structure (A), the structure (C), or the structure (D).

Incidentally, the electromagnetic conducting or absorbing fiber convex structure sections formed on the both surfaces of the substrate and the electromagnetic conducting or absorbing fiber convex structure sections formed in the respective pressure-sensitive adhesive or adhesive layers may be the same electromagnetic conducting or absorbing fiber convex structure section each other or may be a different electromagnetic conducting or absorbing fiber convex structure section from each other. Furthermore, the coating layers which coat the respective electromagnetic conducting or absorbing fiber convex structure sections may be the same coating layer each other or may be a different coating layer from each other. Moreover, the electromagnetic conducting or absorbing fiber convex structure section may be formed entirely on the surface of the substrate or pressure-sensitive adhesive or adhesive layer or may be formed partially on the surface of the substrate or pressure-sensitive adhesive or adhesive layer. In addition, the pressure-sensitive adhesive or adhesive layers formed on the both surfaces of the base material may be the same pressure-sensitive adhesive or adhesive layer each other or may be a different pressure-sensitive or adhesive layer from each other.

[Structure (C)]

As shown in Fig. 7, the structure (C) of the invention has a construction in which an electromagnetic conducting or absorbing fiber convex structure section is formed on one surface of a pressure-sensitive adhesive layer in a form that at least a part of a fiber thereof is positioned outwards from the surface of the pressure-sensitive adhesive layer. Accordingly, in the structure (C), the surface in the side where the electromagnetic conducting or absorbing fiber convex structure section in the pressure-sensitive adhesive layer is not formed serves as a pressure-sensitive adhesive surface. Fig. 7 is an outline cross-sectional view to show a still another example of the structure of the invention. In Fig. 7, 7 stands for the structure (C); 7a stands for a pressure-sensitive adhesive layer; and 7b stands for an electromagnetic conducting or absorbing fiber convex structure section. The structure (C) 7 as shown in Fig. 7 has a construction in which the electromagnetic conducting or absorbing fiber convex structure section 7b is formed on one surface of the pressure-sensitive adhesive layer 7a in a form that at least a part of a fiber thereof is positioned outward from the surface of the pressure-sensitive adhesive layer 7a and the other surface of the pressure-sensitive adhesive layer 7a can be applied as a pressure-sensitive adhesive surface.

[Structure (D)]

As shown in Fig. 8, the structure (D) of the invention has a construction in which an electromagnetic conducting or absorbing fiber convex structure section is formed on each of the both surfaces of a substrate. Fig. 8 is an outline cross-sectional view to show an even another example of the structure of the invention. In Fig. 8, 8 stands for the structure (D); 8a stands for a substrate; and 8b stands for an electromagnetic conducting or absorbing fiber convex structure section. The structure (D) 8 as shown in Fig. 8 has a construction in which the electromagnetic conducting or absorbing fiber convex structure section 8b is formed on each of the both surfaces of the substrate 8a in a form that at least a part of a fiber thereof is positioned outward from the surface of the substrate 8a.

The structures (A) to (D) of the invention are not particularly limited with respect to the form so far as they have the foregoing constructions. Concretely, the structures (A) to (D) may have a form of every kind such as spherical, columnar, polygonal, polygonal conical, conical, plate-like, and sheet-like forms. Of these, a sheet-like form is preferable. That is, it is preferable that the structure of the invention is a sheet-like structure having a sheet-like form. Incidentally, the sheet-like structure can have not only electromagnetic conducting or absorbing properties but also pressure-sensitive adhesive or adhesive properties (in particularly, pressure-sensitive adhesive properties). For example, in the case where the sheet-like structure has pressure-sensitive adhesive properties, the sheet-like structure may have a form of a pressure-sensitive adhesive tape or sheet in which only one surface thereof serves as a pressure-sensitive adhesive surface or may have a form of a double-sided pressure-sensitive adhesive tape or sheet in which the both surfaces thereof serve as a pressure-sensitive adhesive surface (for example, a double-sided pressure-sensitive adhesive tape or sheet of a base material-provided type and a double-sided pressure-sensitive adhesive tape or sheet of a base material-less type). On this occasion, the pressure-sensitive adhesive surface may be any of the surface of the pressure-sensitive adhesive layer in the side where the electromagnetic conducting or absorbing fiber convex structure section is formed and the surface of the pressure-sensitive adhesive layer in the side where the electromagnetic conducting or absorbing fiber convex structure section is not formed.

Incidentally, in the case where the structure of the invention is a sheet-like structure (in particular, a pressure-sensitive adhesive tape or sheet) having a construction in which the surface of the pressure-sensitive adhesive layer in the side where the electromagnetic conducting or absorbing fiber convex structure section is formed has pressure-sensitive adhesive properties, since the subject sheet-like structure has a construction in which the electromagnetic conducting or absorbing fiber convex structure section is partially formed in the pressure-sensitive adhesive layer in a form that at least a part of a fiber thereof is positioned outward from the surface of the pressure-sensitive adhesive layer, the surface of the pressure-sensitive adhesive layer (pressure-sensitive adhesive surface) in the side where at least a part of the fiber of the electromagnetic conducting or absorbing fiber convex structure section is positioned outward from the surface can be adhered to an adherend with sufficient pressure-sensitive adhesive properties while exhibiting electromagnetic conducting or absorbing properties. That is, in the invention, since an electromagnetic conducting or absorbing material such as an electrically conductive material is not blended in the pressure-sensitive adhesive layer but an electromagnetic conducting or absorbing fiber convex structure section is partially formed in the pressure-sensitive adhesive layer, even when electromagnetic conducting or absorbing properties such as electrical conductivity are imparted, the pressure-sensitive adhesive layer can hold an original pressure-sensitive adhesive characteristic.

Furthermore, in the case where the structure of the invention is a sheet-like structure having a construction in which the surface in the side where the electromagnetic conducting or absorbing fiber convex structure section is formed does not have pressure-sensitive adhesive properties, since the subject sheet-like structure has the electromagnetic conducting or absorbing fiber convex structure section entirely on the surface of the pressure-sensitive adhesive layer or substrate, it is possible to exhibit excellent electromagnetic conducting or absorbing properties. Incidentally, in this case, the surface of the pressure-sensitive adhesive layer in the side where the electromagnetic conducting or absorbing fiber convex structure section is not formed may be any of a pressure-sensitive adhesive surface or a non-pressure-sensitive adhesive surface.

Incidentally, in the case where the structure is a sheet-like structure, the subject sheet-like structure can be prepared in a roll-like wound form or in a single-layered or laminated form. Accordingly, the sheet-like structure can be applied as a pressure-sensitive adhesive tape in a roll-like wound form (wound body or rolled body) or a pressure-sensitive adhesive sheet in a single-layered or sheet-laminated form.

In the light of the above, since the structure of the invention has a construction in which the electromagnetic conducting or absorbing fiber convex structure section is formed in the pressure-sensitive adhesive or adhesive layer or substrate in a form that at least a part of a fiber thereof is positioned outward from the surface of the pressure-sensitive adhesive or adhesive layer or substrate, it can be used in a variety of utilities applying electromagnetic conducting or absorbing properties by the electromagnetic conducting or absorbing fiber convex structure section. For example, the structure of the invention can be suitably used in utilities applying electrical conductivity for conducting electricity, electromagnetic shielding properties by conducting or absorbing electromagnetic waves to shield them, or static elimination properties for eliminating electrification by applying an electric current. Concretely, the structure of the invention can be suitably used as an electrically conductive material, an electromagnetic shielding material for shielding electromagnetic waves, or an antistatic material for eliminating electrification to prevent the generation of electrification (or a static-hindrance preventive material to prevent various hindrances due to static). In particularly, the structure of the invention can be suitably used as an electrically conductive material or an electromagnetic shielding material.

In particular, with respect to the structure of the invention, by using, as an electromagnetic conducting or absorbing fiber for forming the electromagnetic conducting or absorbing fiber convex structure section, plural kinds or two or more kinds of electromagnetic conducting or absorbing fibers (for example, plural kinds or two or more kinds of electromagnetic conducting or absorbing raw material fibers and an electromagnetic conducting or absorbing properties-imparted fiber using different metal materials as an electromagnetic conducting or absorbing material, such as plural kinds or two or more kinds of electromagnetic conducting or absorbing material-coated fibers or electromagnetic conducting or absorbing material-impregnated fibers) or by using an electromagnetic conducting or absorbing fiber which is a single kind of an electromagnetic conducting or absorbing fiber but in which plural kinds or two or more kinds of electromagnetic conducting or absorbing materials are used (for example, an electromagnetic conducting or absorbing properties-imparted fiber using plural kinds or two or more kinds of electromagnetic conducting or absorbing materials such as an electromagnetic conducting or absorbing material-coated fibers and an electromagnetic conducting or absorbing material-impregnated fiber), it becomes possible to effectively exhibit a shielding function against not only electromagnetic waves having a single peak wavelength but also electromagnetic waves having plural peak wavelengths. That is, as the electromagnetic conducting or absorbing fiber which constructs the electromagnetic conducting or absorbing fiber convex structure section, by combining plural kinds of electromagnetic conducting or absorbing fibers and properly adjusting a proportion thereof, it is possible to effectively shield electromagnetic waves by a single structure (electromagnetic shielding material) against a radiation source such as a material and a substance, from which plural electromagnetic waves having various peak lengths are emitted in a prescribed proportion. In this way, in the case of using the structure of the invention as an electromagnetic shielding material, the type of the radiation source from which electromagnetic waves are emitted is not limited, and it is possible to easily prepare the electromagnetic shielding material in a construction that a shielding function can be exhibited against a radiation source of a wide range. Accordingly, in the invention, it is possible to easily obtain an electromagnetic shielding material capable of performing shielding by much more effectively conducting or absorbing electromagnetic waves.

Incidentally, concretely, in the case where an electromagnetic conducting or absorbing properties-imparted fiber is used as the electromagnetic conducting or absorbing fiber, in metal materials in the electromagnetic conducting or absorbing material which constructs the electromagnetic conducting or absorbing properties-imparted fiber, for example, nickel and gold, the type or wavelength of electromagnetic waves capable of performing shielding by conducting or absorbing electromagnetic waves is different therebetween. Accordingly, for example, when the electromagnetic conducting or absorbing fiber convex structure section is formed by using, as the electromagnetic conducting or absorbing fiber, a nickel plated fiber and a gold plated fiber, the resulting electromagnetic shielding material can efficiently exhibit an electromagnetic shielding effect by nickel and an electromagnetic shielding effect by gold, respectively, thereby enabling one to effectively shield electromagnetic waves.

Furthermore, in the foregoing structure, it is possible to perform electric conduction, application of an electric current, or the like from the surface of the electromagnetic conducting or absorbing fiber which forms the electromagnetic conducting or absorbing fiber convex structure section. For example, by forming the electromagnetic conducting or absorbing fiber convex structure section entirely on the surface of the pressure-sensitive adhesive or adhesive layer or substrate, it is also possible to make the surface area of the foregoing electromagnetic conducting or absorbing fiber larger than the surface area of the surface of the pressure-sensitive adhesive or adhesive layer or substrate. For that reason, it is possible to efficiently exhibit functions such as much more excellent electromagnetic shielding properties as compared with conventional various base materials which are used in utilities by applying electromagnetic conducting or absorbing properties such as electromagnetic shielding materials.

In addition, the electromagnetic conducting or absorbing fiber convex structure is formed in a form that at least a part of the fiber is positioned outward from the surface of the pressure-sensitive adhesive or adhesive layer or substrate. In applying the structure of the invention as an electromagnetic shielding material or the like, it can be constructed such that the structure of the invention can be used in a form that regardless of the surface shape of a body for achieving shielding electromagnetic waves, etc., at least a part of the fiber of the electromagnetic conducting or absorbing fiber convex structure section is brought into contact with the surface of the body of every kind. Therefore, it is possible to much more effectively exhibit electromagnetic shielding properties, etc.

In addition, by properly adjusting the length of the electromagnetic conducting or absorbing fiber, the density of the electromagnetic conducting or absorbing fiber in the electromagnetic conducting or absorbing fiber convex structure section, etc. as well as the type of the electromagnetic conducting or absorbing fiber for forming the electromagnetic conducting or absorbing fiber convex structure section, it is possible to make the structure of the invention serve as a structure capable of exhibiting the desired or adequate electrical conductivity and electromagnetic shielding properties and the like.

Incidentally, for the purpose of much more conducting or absorbing electromagnetic waves, the structure of the invention may be grounded.

Furthermore, the structure of the invention can be used in various utilities applying various characteristics such as soundproofing, thermal conductivity, light reflection properties, and design properties as well as various utilities applying electromagnetic conducting or absorbing properties.

Incidentally, in the case where the structure of the invention has a construction in which the electromagnetic conducting or absorbing fiber convex structure section is formed partially on the surface of the pressure-sensitive adhesive layer, it is possible to use the structure of the invention in a firmly adhered state after superimposing it on an adherend to achieve temporary adhering and performing position correction.

A production method of the structures (A) to (D) of the invention includes a step for forming an electromagnetic conducting or absorbing fiber convex structure section in a prescribed site on a prescribed surface in a pressure-sensitive adhesive or adhesive layer or a substrate by applying, for example, a flocking processing method. Accordingly, it is possible to produce a structure having electromagnetic conducting or absorbing properties easily and cheaply by a simple method, for example, flocking of an electromagnetic conducting or absorbing fiber.

Concretely, by subjecting a prescribed site in the pressure-sensitive adhesive or adhesive layer or substrate to flocking processing by applying the flocking processing method, a structure having the electromagnetic conducting or absorbing fiber convex structure section in the pressure-sensitive adhesive or adhesive layer or substrate can be produced by forming the electromagnetic conducting or absorbing fiber convex structure section in a form that at least a part of the fiber is positioned outward from the surface of the pressure-sensitive adhesive or adhesive layer or substrate in a prescribed site of the foregoing pressure-sensitive adhesive or adhesive layer or substrate. As such a blocking processing method, an electrostatic flocking processing method is especially suitable. Incidentally, as the electrostatic flocking processing method, for example, there is enumerated a processing method in which a material to be flocked having a pressure-sensitive adhesive or adhesive layer or a substrate is set as a counter electrode to one electrode; a direct current high voltage is applied thereto; flocks (fibers) are supplied between these electrodes; and the flocks are flied along the line of electric force due to a Coulomb force and made to stick into the surface of the material to be flocked (for example, the surface of the pressure-sensitive adhesive or adhesive layer or substrate and the wall surface of the concave of the pressure-sensitive adhesive or adhesive layer or substrate), thereby achieving flocking. Such an electrostatic flocking processing method is not particularly limited so far as it is a known electrostatic flocking method. For example, any of an up method, a down method and a side method as described in "Principle and Truth of Electrostatic Flocking" in *SENI* (Fiber), Vol. 34, No. 6 (1982-6) may be employed.

Incidentally, in forming the electromagnetic conducting or absorbing fiber convex structure section in a prescribed partial site of the pressure-sensitive adhesive or adhesive layer or substrate (for example, a prescribed partial site of the surface of the pressure-sensitive adhesive or adhesive layer or substrate and a wall surface of the concave formed partially in the pressure-sensitive adhesive or adhesive layer or substrate) but not an entire surface thereof by the flocking processing method (in particular, the electrostatic flocking processing method), as described previously, it is preferred to use a release base material in which at least one surface thereof is a release surface and which is provided with a hole section (hereinafter sometimes referred to as "hole section-containing release base material"). By using the hole section-containing release base material, it is possible to form efficiently and easily the electromagnetic conducting or absorbing fiber convex structure section in a prescribed partial site of, for example, the surface of the pressure-sensitive adhesive or adhesive layer or the wall surface of the concave. Concretely, by subjecting a prescribed site of the pressure-sensitive adhesive or adhesive layer or substrate in a state that the release base material having a hole section in the position corresponding to a prescribed partial site where the electromagnetic conducting or absorbing fiber convex structure section in the pressure-sensitive adhesive or adhesive layer or substrate is to be formed is superimposed on the surface of the pressure-sensitive adhesive or adhesive layer or substrate to flocking processing (in particular, electrostatic flocking processing), it is possible to form the electromagnetic conducting or absorbing fiber convex structure section in the prescribed site of the pressure-sensitive adhesive or adhesive layer or substrate corresponding to the hole section of the release base material. As such a hole section-containing release base material, the foregoing release liner having a hole section (in particular, a perforated section) can be used. Above all, a release film having a hole section (in particular, a perforated section) in which the base material for release liner is a plastic base material is suitable.

In this way, by a method for producing a structure having an electromagnetic conducting and absorbing fiber convex structure section partially in a prescribed site (in particular, the surface) of the pressure-sensitive adhesive or adhesive layer or substrate by using a hole section-containing release base material, it is possible to control the position at which the electromagnetic conducting or absorbing fiber convex structure section on the surface of the pressure-sensitive adhesive or adhesive layer or substrate is to be formed, the size and number of the electromagnetic conducting or absorbing fiber convex structure section, the concave for forming the electromagnetic conducting or absorbing fiber convex structure section, and so on, depending upon the position at which the hole section of the release base material is to be formed and the size and number of the hole section of the release base material.

After forming the electromagnetic conducting or absorbing fiber convex structure section, while the foregoing hole section-containing release base material may be released, in the case of using the pressure-sensitive adhesive or adhesive layer, it is preferable that the hole section-containing release base material is used as the release liner as it is. Incidentally, in the case where after forming the electromagnetic conducting or absorbing fiber convex structure section, the hole section-containing release base material is released and removed, the surface from which the fiber of the electromagnetic conducting or absorbing fiber convex structure section in the pressure-sensitive adhesive or adhesive layer is protruded can be protected by the release liner having a concave (in particular, the release liner having a concave in a portion or site in which the fiber of the electromagnetic conducting or absorbing fiber convex structure section in the pressure-sensitive adhesive or adhesive layer is protruded).

Incidentally, in the invention, the electromagnetic conducting or absorbing properties (in particular, the electrical conductivity) of the structure can be evaluated by measuring a volume specific resistance according to JIS K6705. The electromagnetic conducting or absorbing properties of the structure can be controlled depending upon the size of the respective electromagnetic conducting or absorbing fiber convex structure section which is formed in the pressure-sensitive adhesive or adhesive layer or substrate (the occupied area of one electromagnetic conducting or absorbing fiber convex structure section) and the shape thereof, the proportion of the whole electromagnetic conducting or absorbing fiber convex structure section formed in the pressure-sensitive adhesive or adhesive layer or substrate to the entire surface of the pressure-sensitive adhesive or adhesive or the entire surface of the substrate (the proportion of the occupied area of the whole electromagnetic conducting or absorbing fiber convex structure section), the shape (length and thickness) and raw material of the fiber in the electromagnetic conducting or absorbing fiber convex structure section, and the like.

Since the structure of the invention has the foregoing construction, it has a characteristic of conducting or absorbing electromagnetic waves at an excellent level and is produced easily and cheaply. For that reason, the structure of the invention can be suitably applied as an electrically conductive material or an electromagnetic shielding material.

The invention will be described below in detail with reference to the following Examples, but it should not be construed that the invention is limited to these Examples. Incidentally, in the Examples and Comparative Examples, electrostatic flocking processing was carried out by using a box provided with a line capable of spraying a fiber in the positively charged state and of flowing a longitudinal strip-form sheet in the negatively charged state from one side to the other side (size: 2.5 m (length in the line flow direction) × 1.3 m (width) × 1.4 m (height)). Concretely, the electrostatic flocking processing was carried out by spraying the fiber from an upper portion (one portion) within the foregoing box and introducing and moving the longitudinal strip-form sheet within the box at a line speed of 5 m/min. in the state of spraying at an applied voltage of 30 kV such that the surface on which the fiber was to be formed was positioned in the upper side.

EXAMPLE 1

On one surface of an aluminum-made base material (thickness: 10 μm) as an electromagnetic conducting or absorbing base material, an acrylic pressure-sensitive adhesive (base polymer: butyl acrylate/acrylic acid copolymer) having 35 % by weight (proportion based on the whole amount of solids) of a nickel powder blended therein was coated in a thickness after drying of 30 μm to form an electromagnetic conducting or absorbing pressure-sensitive adhesive layer. Thereafter, the entire surface of the subject electromagnetic conducting or absorbing pressure-sensitive adhesive layer was subjected to electrostatic flocking processing by using, as an electromagnetic conducting or absorbing fiber, an acrylic fiber whose surface had been subjected to a nickel plating treatment (a plating treatment with nickel) (fiber thickness: 3 deniers, fiber length: 0.5 mm), thereby flocking the foregoing acrylic fiber whose surface had been subjected to a nickel plating treatment on the entire surface of the foregoing electromagnetic conducting or absorbing pressure-sensitive adhesive layer. There was thus prepared a sheet-like structure in a form that a fiber napping section (electromagnetic conducting or absorbing fiber napping section) composed of the electromagnetic conducting or absorbing fiber (acrylic fiber whose surface had been subjected to a nickel plating treatment) was formed entirely on the surface of the electromagnetic conducting or absorbing pressure-sensitive adhesive layer formed on the electromagnetic conducting or absorbing base material (the sheet-like structure will be hereinafter sometimes referred to as "sheet-like structure A1") as shown in Fig. 5A.

Incidentally, in the sheet-like structure A1, the electromagnetic conducting or absorbing fiber which was most protruded from the surface of the electromagnetic conducting or absorbing pressure-sensitive adhesive layer was protruded by about 0.5 mm from the surface of the electromagnetic conducting or absorbing pressure-sensitive adhesive layer. That is, with respect to the electromagnetic conducting or absorbing fiber in the electromagnetic conducting or absorbing fiber napping section, a distance between the tip of the electromagnetic conducting or absorbing fiber which was most protruded from the surface of the electromagnetic conducting or absorbing pressure-sensitive adhesive layer and the surface of the electromagnetic conducting or absorbing pressure-sensitive adhesive layer was about 0.5 mm.

EXAMPLE 2

The same procedures as in Example 1 were followed, except for using, as the electromagnetic conducting or absorbing fiber, an acrylic fiber (fiber thickness: 3 deniers, fiber length: 0.5 mm) whose surface had been subjected to a copper-nickel plating treatment (a plating treatment with a copper-nickel alloy), thereby preparing a sheet-like structure (hereinafter sometimes referred to as "sheet-like structure A2") in a form that an electromagnetic conducting or absorbing fiber napping section (a fiber napping section composed of an acrylic fiber whose surface had been subjected to a copper-nickel plating treatment) was formed entirely on the surface of the electromagnetic conducting or absorbing pressure-sensitive adhesive layer formed on the electromagnetic conducting or absorbing base material.

EXAMPLE 3

The same procedures as in Example 1 were followed, except for using, as the electromagnetic conducting or absorbing fiber, an acrylic fiber (fiber thickness: 3 deniers, fiber length: 0.5 mm) whose surface had been subjected to a copper plating treatment (a plating treatment with copper), thereby preparing a sheet-like structure (hereinafter sometimes referred to as "sheet-like structure A3") in a form that an electromagnetic conducting or absorbing fiber napping section (a fiber napping section composed of an acrylic fiber whose surface had been subjected to a copper plating treatment) was formed entirely on the surface of the electromagnetic conducting or absorbing pressure-sensitive adhesive layer formed on the electromagnetic conducting or absorbing base material.

EXAMPLE 4

The same procedures as in Example 1 were followed, except for using, as the electromagnetic conducting or absorbing base material, an aluminum-made base material (thickness: 60 $\mu$m), thereby preparing a sheet-like structure (hereinafter sometimes referred to as "sheet-like structure A4") in a form that an electromagnetic conducting or absorbing fiber napping section (a fiber napping section composed of an acrylic fiber whose surface had been subjected to a nickel plating treatment) was formed entirely on the surface of the electromagnetic conducting or absorbing pressure-sensitive adhesive layer formed on the electromagnetic conducting or absorbing base material.

EXAMPLE 5

The same procedures as in Example 2 were followed, except for using, as the electromagnetic conducting or absorbing base material, an aluminum-made base material (thickness: 60 $\mu$m), thereby preparing a sheet-like structure (hereinafter sometimes referred to as "sheet-like structure A5") in a form that an electromagnetic conducting or absorbing fiber napping section (a fiber napping section composed of an acrylic fiber whose surface had been subjected to a copper-nickel plating treatment) was formed entirely on the surface of the electromagnetic conducting or absorbing pressure-sensitive adhesive layer formed on the electromagnetic conducting or absorbing base material.

EXAMPLE 6

The same procedures as in Example 3 were followed, except for using, as the electromagnetic conducting or absorbing base material, an aluminum-made base material (thickness: 60 $\mu$m), thereby preparing a sheet-like structure (hereinafter sometimes referred to as "sheet-like structure A6") in a form that an electromagnetic conducting or absorbing fiber napping section (a fiber napping section composed of an acrylic fiber whose surface had been subjected to a copper plating treatment) was formed entirely on the surface of the electromagnetic conducting or absorbing pressure-sensitive adhesive layer formed on the electromagnetic conducting or absorbing base material.

EXAMPLE 7

The same procedures as in Example 1 were followed, except for using, as the electromagnetic conducting or absorbing base material, an aluminum-made base material (thickness: 300 $\mu$m), thereby preparing a sheet-like structure (hereinafter sometimes referred to as "sheet-like structure A7") in a form that an electromagnetic conducting or absorbing fiber napping section (a fiber napping section composed of an acrylic fiber whose surface had been subjected to a nickel plating treatment) was formed entirely on the surface of the electromagnetic conducting or absorbing pressure-sensitive adhesive layer formed on the electromagnetic conducting or absorbing base material.

EXAMPLE 8

The same procedures as in Example 2 were followed, except for using, as the electromagnetic conducting or absorbing base material, an aluminum-made base material (thickness: 300 $\mu$m), thereby preparing a sheet-like structure (hereinafter sometimes referred to as "sheet-like structure A8") in a form that an electromagnetic conducting or absorbing fiber napping section (a fiber napping section composed of an acrylic fiber whose surface had been subjected to a copper-nickel plating treatment) was formed entirely on the surface of the electromagnetic conducting or absorbing pressure-sensitive adhesive layer formed on the electromagnetic conducting or absorbing base material.

EXAMPLE 9

The same procedures as in Example 3 were followed, except for using, as the electromagnetic conducting or absorbing base material, an aluminum-made base material (thickness: 300 $\mu$m), thereby preparing a sheet-like structure (hereinafter sometimes referred to as "sheet-like structure A9") in a form that an electromagnetic conducting or absorbing fiber napping section (a fiber napping section composed of an acrylic fiber whose surface had been subjected to a copper plating treatment) was formed entirely on the surface of the electromagnetic conducting or absorbing pressure-sensitive adhesive layer formed on the electromagnetic conducting or absorbing base material.

EXAMPLE 10

The same procedures as in Example 1 were followed, except for using, as the electromagnetic conducting or absorbing base material, an aluminum-made base material (thickness: 500 $\mu$m), thereby preparing a sheet-like structure (hereinafter sometimes referred to as "sheet-like structure A10") in a form that an electromagnetic conducting or absorbing fiber napping section (a fiber napping section composed of an acrylic fiber whose surface had been subjected to a nickel plating treatment) was formed entirely on the surface of the electromagnetic conducting or absorbing pressure-sensitive adhesive layer formed on the electromagnetic conducting or absorbing base material.

EXAMPLE 11

The same procedures as in Example 2 were followed, except for using, as the electromagnetic conducting or absorbing base material, an aluminum-made base material (thickness: 500 $\mu$m), thereby preparing a sheet-like structure (hereinafter sometimes referred to as "sheet-like structure A11") in a form that an electromagnetic conducting or absorbing fiber napping section (a fiber napping section composed of an acrylic fiber whose surface had been subjected to a copper-nickel plating treatment) was formed entirely on the surface of the electromagnetic conducting or absorbing pressure-sensitive adhesive layer formed on the electromagnetic conducting or absorbing base material.

EXAMPLE 12

The same procedures as in Example 3 were followed, except for using, as the electromagnetic conducting or absorbing base material, an aluminum-made base material (thickness: 500 $\mu$m), thereby preparing a sheet-like structure (hereinafter sometimes referred to as "sheet-like structure A12") in a form that an electromagnetic conducting or absorbing fiber napping section (a fiber napping section composed of an acrylic fiber whose surface had been subjected to a copper plating treatment) was formed entirely on the surface of the electromagnetic conducting or absorbing pressure-sensitive adhesive layer formed on the electromagnetic conducting or absorbing base material.

EXAMPLE 13

The same procedures as in Example 1 were followed, except for using, as the electromagnetic conducting or absorbing base material, a copper-made base material (thickness: 40 $\mu$m), thereby preparing a sheet-like structure (hereinafter sometimes referred to as "sheet-like structure A13") in a form that an electromagnetic conducting or absorbing fiber napping section (a fiber napping section composed of an acrylic fiber whose surface had been subjected to a nickel plating treatment) was formed entirely on the surface of the electromagnetic conducting or absorbing pressure-sensitive adhesive layer formed on the electromagnetic conducting or absorbing base material.

EXAMPLE 14

The same procedures as in Example 2 were followed, except for using, as the electromagnetic conducting or absorbing base material, a copper-made base material (thickness: 40 $\mu$m), thereby preparing a sheet-like structure (hereinafter sometimes referred to as "sheet-like structure A14") in a form that an electromagnetic conducting or absorbing fiber napping section (a fiber napping section composed of an acrylic fiber whose surface had been subjected to a copper-nickel plating treatment) was formed entirely on the surface of the electromagnetic conducting or absorbing pressure-sensitive adhesive layer formed on the electromagnetic conducting or absorbing base material.

EXAMPLE 15

The same procedures as in Example 3 were followed, except for using, as the electromagnetic conducting or absorbing base material, a copper-made base material (thickness: 40 $\mu$m), thereby preparing a sheet-like structure (hereinafter sometimes referred to as "sheet-like structure A15") in a form that an electromagnetic conducting or absorbing fiber napping section (a fiber napping section composed of an acrylic fiber whose surface had been subjected to a copper plating treatment) was formed entirely on the surface of the electromagnetic conducting or absorbing pressure-sensitive adhesive layer formed on the electromagnetic conducting or absorbing base material.

EXAMPLE 16

On the both surfaces of an aluminum-made base material (split-provided) as an electromagnetic conducting or absorbing base material, an acrylic pressure-sensitive adhesive (base polymer: butyl acrylate/acrylic acid copolymer) having 35 % by weight (proportion based on the whole amount of solids) of a nickel powder blended therein was coated in a thickness after drying of 30 $\mu$m to form an electromagnetic conducting or absorbing pressure-sensitive adhesive layer. Thereafter, the entire surface of the subject electromagnetic conducting or absorbing pressure-sensitive adhesive layer was subjected to electrostatic flocking processing by using, as an electromagnetic conducting or absorbing fiber, an acrylic fiber whose surface had been subjected to a copper plating treatment (a plating treatment with copper) (fiber thickness: 3 deniers, fiber length: 0.5 mm), thereby flocking the foregoing acrylic fiber whose surface had been subjected to a copper plating treatment on the entire surface of the foregoing electromagnetic conducting or absorbing pressure-sensitive adhesive layer. There was thus prepared a sheet-like structure in a form that a fiber napping section (electromagnetic conducting or absorbing fiber napping section) composed of the electromagnetic conducting or absorbing fiber (acrylic fiber whose surface had been subjected to a copper plating treatment) was formed entirely on each surface (both surfaces) of the electromagnetic conducting or absorbing pressure-sensitive adhesive layer formed on the electromagnetic conducting or absorbing base material (the sheet-like structure will be hereinafter sometimes referred to as "sheet-like structure A16") as shown in Fig. 5B.

EXAMPLE 17

The same procedures as in Example 16 were followed, except for using, as the electromagnetic conducting or absorbing fiber, an acrylic fiber (fiber thickness: 3 deniers, fiber length: 0.5 mm) whose surface had been subjected to a copper-nickel plating treatment (a plating treatment with a copper-nickel alloy), thereby preparing a sheet-like structure (hereinafter sometimes referred to as "sheet-like structure A17") in a form that an electromagnetic conducting or absorbing fiber napping section (a fiber napping section composed of an acrylic fiber whose surface had been subjected to a copper-nickel plating treatment) was formed entirely on the surface of the electromagnetic conducting or absorbing pressure-sensitive adhesive layer formed on each surface (both surfaces) of the electromagnetic conducting or absorbing base material.

EXAMPLE 18

The same procedures as in Example 16 were followed, except for using, as the electromagnetic conducting or absorbing fiber, an acrylic fiber (fiber thickness: 3 deniers, fiber length: 0.5 mm) whose surface had been subjected to a nickel plating treatment (a plating treatment with nickel), thereby preparing a sheet-like structure (hereinafter sometimes referred to as "sheet-like structure A18") in a form that an electromagnetic conducting or absorbing fiber napping section (a fiber napping section composed of an acrylic fiber whose surface had been subjected to a nickel plating treatment) was formed entirely on the surface of the electromagnetic conducting or absorbing pressure-sensitive adhesive layer formed on each surface (both surfaces) of the electromagnetic conducting or absorbing base material.

COMPARATIVE EXAMPLE 1

A sheet-like structure composed of only an aluminum-made base material (thickness: 10 $\mu$m) (hereinafter sometimes referred to as "sheet-like structure B1") was prepared.

COMPARATIVE EXAMPLE 2

A sheet-like structure composed of only an aluminum-made base material (thickness: 60 $\mu$m) (hereinafter sometimes referred to as "sheet-like structure B2") was prepared.

COMPARATIVE EXAMPLE 3

A sheet-like structure composed of only an aluminum-made base material (thickness: 300 $\mu$m) (hereinafter sometimes referred to as "sheet-like structure B3") was prepared.

COMPARATIVE EXAMPLE 4

A sheet-like structure composed of only an aluminum-made base material (thickness: 500 $\mu$m) (hereinafter sometimes referred to as "sheet-like structure B4") was prepared.

COMPARATIVE EXAMPLE 5

A sheet-like structure composed of only a copper-made base material (thickness: 40 $\mu$m) (hereinafter sometimes referred to as "sheet-like structure B5") was prepared.
Accordingly, neither an electromagnetic conducting or absorbing pressure-sensitive adhesive layer nor an electromagnetic conducting or absorbing fiber napping section is provided in the sheet-like structures B1 to B5 according to Comparative Examples 1 to 5.

COMPARATIVE EXAMPLE 6

On a release treated surface of a release liner, an acrylic pressure-sensitive adhesive (base polymer: butyl acrylate/acrylic acid copolymer) having 35 % by weight (proportion based on the whole amount of solids) of a nickel powder blended therein was coated in a thickness after drying of 30 $\mu$m to form an electromagnetic conducting or absorbing pressure-sensitive adhesive layer. There was thus prepared a sheet-like structure (hereinafter sometimes referred to as "sheet-like structure B6"). Accordingly, the sheet-like structure B6 contains only the electromagnetic conducting or absorbing pressure-sensitive adhesive layer and is provided with neither an electromagnetic conducting or absorbing base material nor an electromagnetic conducting or absorbing fiber napping section.

COMPARATIVE EXAMPLE 7

A sheet-like structure composed of only an aluminum-made base material (split-provided) was prepared (hereinafter sometimes referred to as "sheet-like structure B7"). The subject aluminum-made base material (split-provided) is the same as the aluminum-made base material (split-provided) as used in Examples 16 to 18.

(Evaluation)

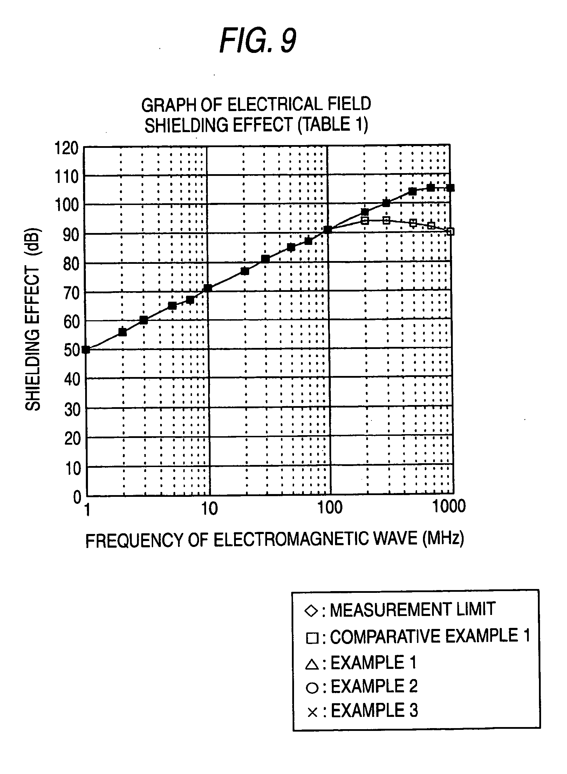

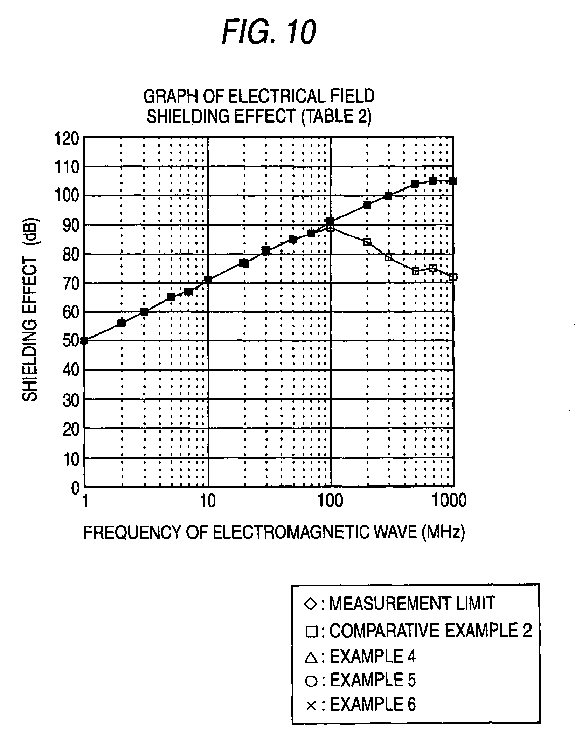

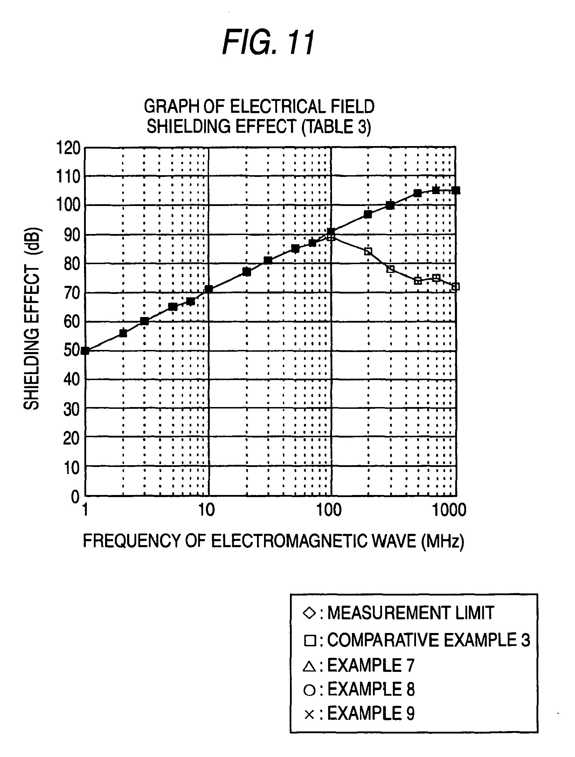

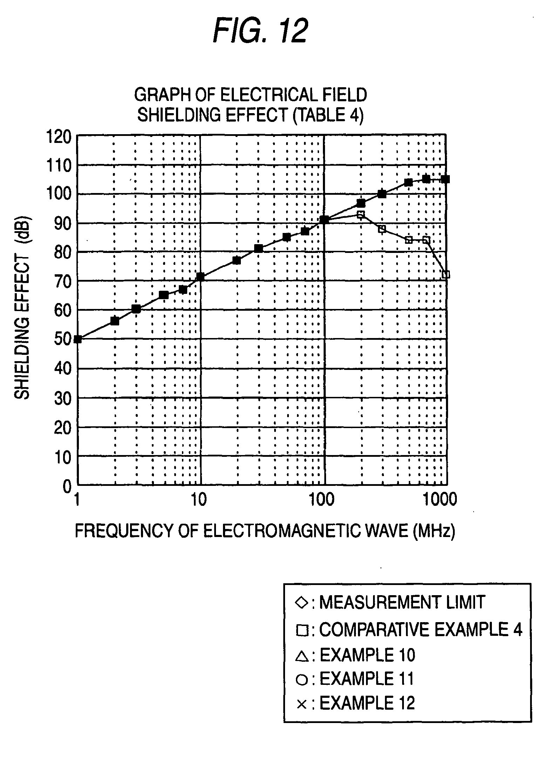

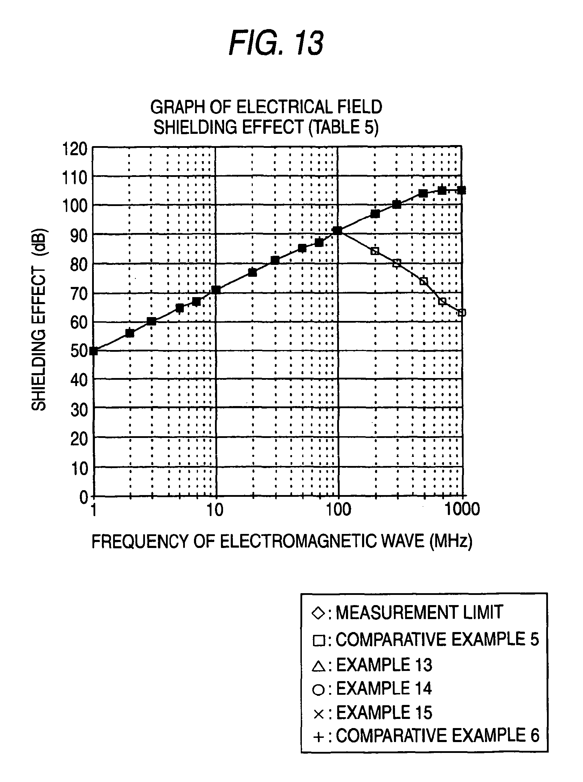

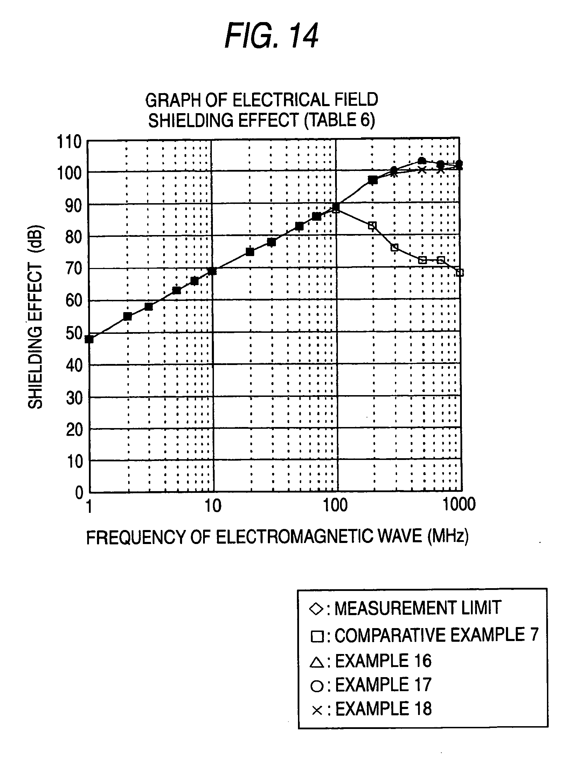

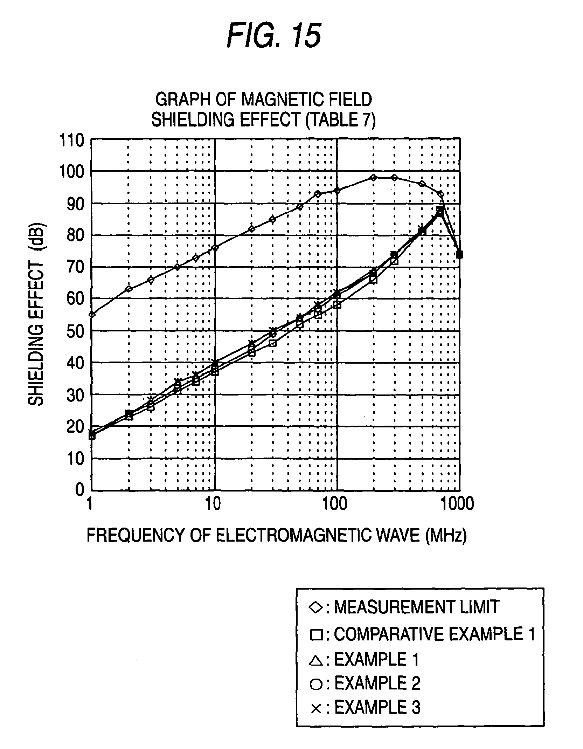

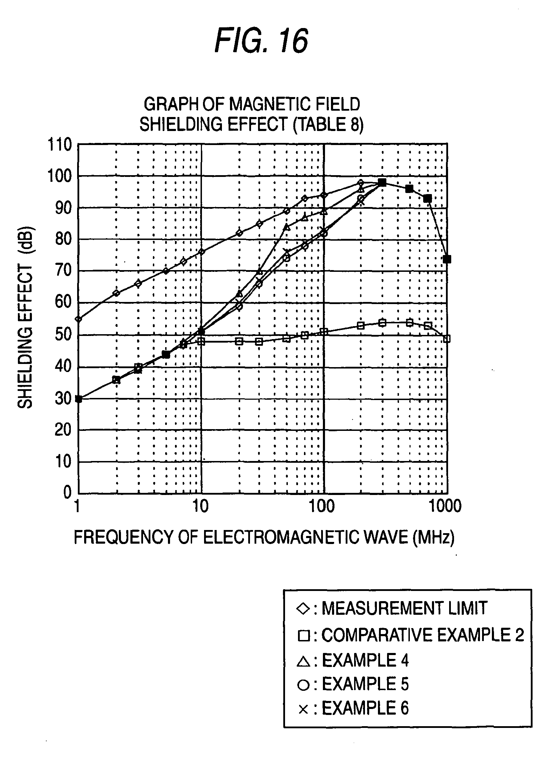

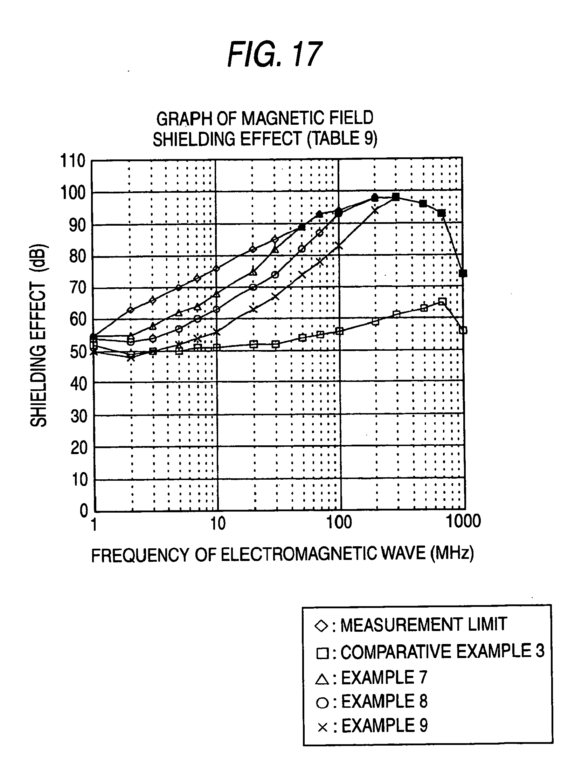

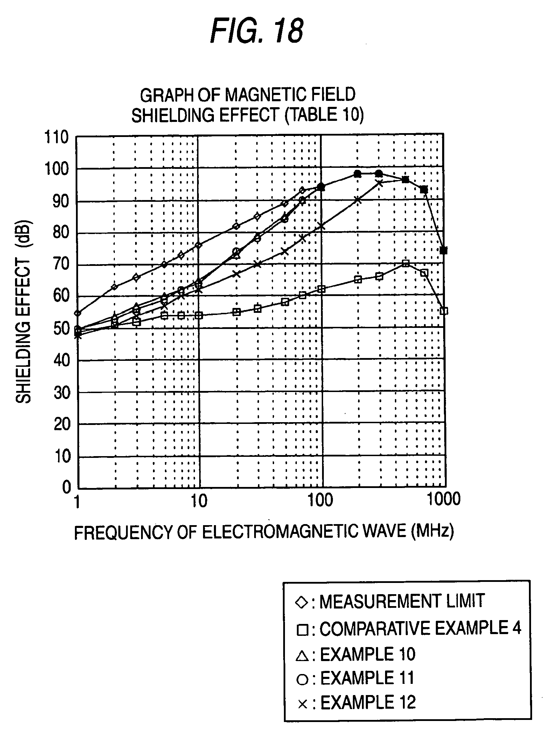

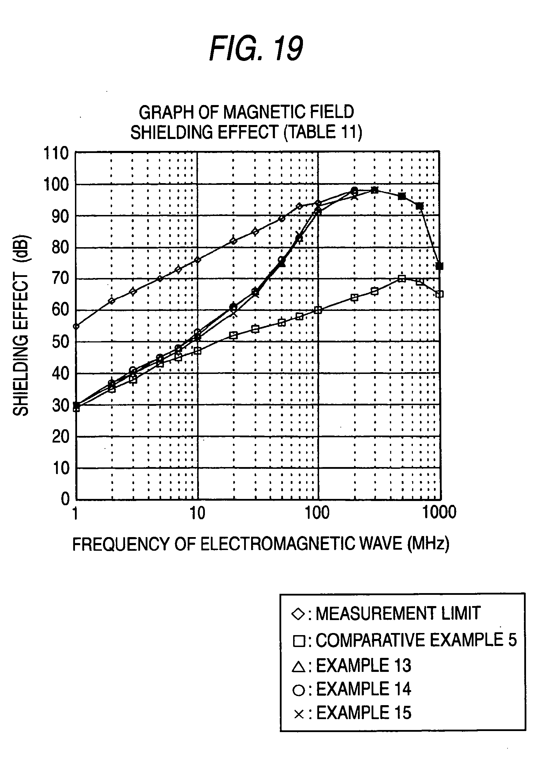

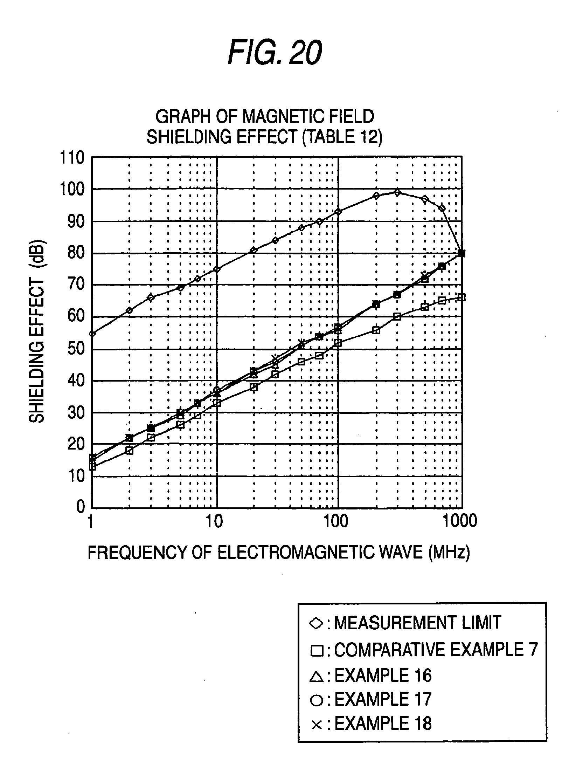

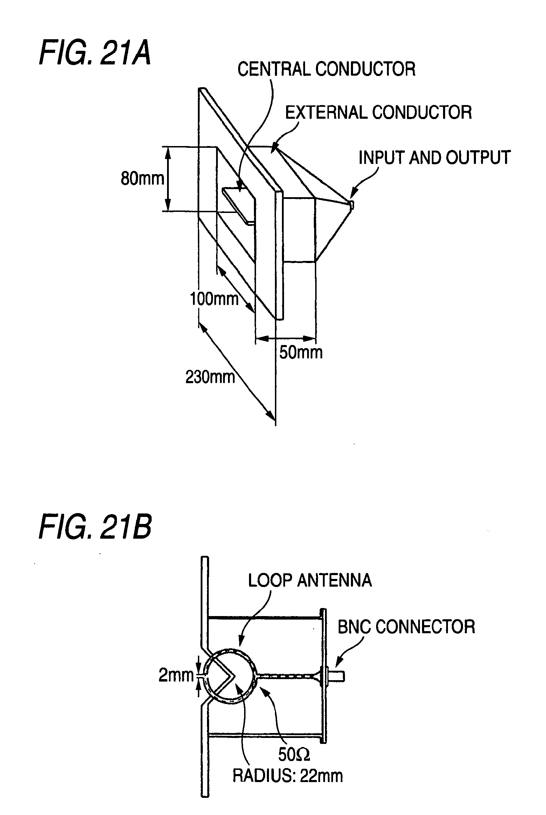

With respect to the sheet-like structures A1 to A18 as obtained in Examples 1 to 18 and the sheet-like structures B1 to B7 as obtained in Comparative Examples 1 to 7, an electrical field shielding effect and a magnetic shielding effect were respectively evaluated by using an electromagnetic shielding evaluation system by the KEC method. The evaluation results are shown in Tables 1 to 12, and graphs thereof are shown in Figs. 9 to 20. Incidentally, the graphs as shown in Figs. 9 to 14 are those resulting from graphing the contents of Tables 1 to 6, respectively and are each a graph regarding the electrical field shielding effect. In the graphs as shown in Figs. 9 to 14, the abscissa shows a frequency (MHz) of an electromagnetic wave as applied, and the ordinate shows a shielding effect (dB). Also, the graphs as shown in Figs. 15 to 20 are those resulting from graphing the contents of Tables 7 to 12, respectively and are each a graph regarding the magnetic field shielding effect. In the graphs as shown in Figs. 15 to 20, the abscissa shows a frequency (MHz) of an electromagnetic wave as applied, and the ordinate shows a shielding effect (dB).
Incidentally, the KEC method in the electromagnetic shielding evaluation system by the KEC method is a method as developed by Kansai Electronic Industry Development Center. According to this method, the shielding effect in the near electromagnetic field is evaluated by using an amplifier and a spectrum analyzer and respective shielding boxes (a shielding box for electrical field and a shielding box for magnetic field) marketed from Anritsu Corp. Concretely, by using a shielding box for electrical field as shown in Fig. 21A or a shielding box for magnetic field as shown in Fig. 21B, the sheet-like structure is placed in a prescribed position; an electromagnetic wave having a prescribed frequency (MHz) (incident wave: incident electrical field or incident magnetic field) is made incident with prescribed energy (hereinafter sometimes referred to as "E1") from the side of the electromagnetic conducting or absorbing fiber convex structure section of the sheet-like structure; energy (hereinafter sometimes referred to as "E2") of a transmitted wave (transmitted electrical field or transmitted magnetic field) which has transmitted into the other surface of the sheet-like structure is measured; and the shielding effect (dB) is determined according to the following expression (1).

$$\texttt{Shielding effect (dB) = 20} \times \texttt{log (E2/E1)} \qquad \texttt{(1)}$$

Figs. 21A and 21B each is an outline view to show a shielding box to be used in the electromagnetic shielding evaluation system by the KEC method; and Fig. 21A shows a shielding box for electrical field, while Fig. 21B shows a shielding box for magnetic field. The shielding box for electrical field (unit for electrical field shielding evaluation) has a structure in which dimensional distribution of a TEM cell is employed and the inside of the plane vertical to the transmission axis direction is divided bilaterally symmetrically. However, a short circuit is prevented from the formation by inserting a measurement sample. Furthermore, the shielding box for magnetic field (unit for magnetic field shielding evaluation) has a structure in which a shield type circular loop antenna is used for the purpose of generating a large electromagnetic field of the magnetic field component and combined with a metal plate of 90° square such that a 1/4 portion of the loop antenna is exposed outward.

Incidentally, with respect to the shielding effect, the details are described in *Denjiha Shahei Gijutsu* (Electromagnetic Shielding Technologies) (pages 253 to 269) in *Tokkyo Mappu Shirizu: Denki 23* (Patent Map Series: Electricity 23) published by Japan Institute of Invention and Innovation, etc. In this document, it is described that an index to what extent the electromagnetic energy of the incident electrical field or incident magnetic field can be decayed is the shielding effect, and the shield effect is expressed as a value resulting from multiplication of a common logarithm of a ratio of the electromagnetic energy of the transmitted electrical field or transmitted magnetic field to the electromagnetic energy of the incident electrical field or incident magnetic field by twenty (unit: dB), respectively. Also, with respect to the shielding effect, it is described (on pages 254 to 253) that as the standard of the shield effect, the shielding effect is not substantially revealed at from 0 to 10 dB; the shielding effect is the minimum at from 10 to 30 dB; the shielding effect is an average level at from 30 to 60 dB; the shielding effect is considerably revealed at from 60 to 90 dB; and the shielding effect is the maximum at 90 dB or more.

In the foregoing KEC method, a measurement limit is different between the low frequency region and the high frequency region. This is because a transmission characteristic of shielding (aluminum shielding plate) is constant regardless of the frequency (-105 dBm over from 1 MHz to 1 GHz in the electrical field shielding box), while a transmission characteristic of the through has a frequency characteristic (the transmission characteristic is decayed to about -50 dBm in the low frequency side, whereas substantially the same as 0 dBm as in the transmitting side is received in the high frequency side). Incidentally, it is thought that the transmission characteristic of shielding (2 mm-thick aluminum shielding plate) is actually a much smaller value and that "-105 dBm" is a noise level (ability) of the spectrum analyzer. Also, it is thought that if the noise level (ability) of the spectrum analyzer becomes higher, the transmission characteristic of shielding (aluminum shielding plate) becomes a smaller value, and a difference from the though becomes large, whereby the measurement limit is expanded. However, since when expressed in terms of electrical power, "-105 dBm" is a very small value as not more than 0.1 pW, it is considered that more enhancement is difficult.

Table 1

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 50 | 56 | 60 | 65 | 67 | 71 | 77 | 81 | 85 | 87 | 91 | 97 | 100 | 104 | 105 | 105 |
| Example 1 (dB) | 50 | 56 | 60 | 65 | 67 | 71 | 77 | 81 | 85 | 87 | 91 | 97 | 100 | 104 | 105 | 105 |
| Example 2 (dB) | 50 | 56 | 60 | 65 | 67 | 71 | 77 | 81 | 85 | 87 | 91 | 97 | 100 | 104 | 105 | 105 |
| Example 3 (dB) | 50 | 56 | 60 | 65 | 67 | 71 | 77 | 81 | 85 | 87 | 91 | 97 | 100 | 104 | 105 | 105 |
| Comparative Example 1 (dB) | 50 | 56 | 60 | 65 | 67 | 71 | 77 | 81 | 85 | 87 | 91 | 94 | 94 | 93 | 92 | 90 |

Table 2

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 50 | 56 | 60 | 65 | 67 | 71 | 77 | 81 | 85 | 87 | 91 | 97 | 100 | 104 | 105 | 105 |
| Example 4 (dB) | 50 | 56 | 60 | 65 | 67 | 71 | 77 | 81 | 85 | 87 | 91 | 97 | 100 | 104 | 105 | 105 |
| Example 5 (dB) | 50 | 56 | 60 | 65 | 67 | 71 | 77 | 81 | 85 | 87 | 91 | 97 | 100 | 104 | 105 | 105 |
| Example 6 (dB) | 50 | 56 | 60 | 65 | 67 | 71 | 77 | 81 | 85 | 87 | 91 | 97 | 100 | 104 | 105 | 105 |
| Comparative Example 2 (dB) | 50 | 56 | 60 | 65 | 67 | 71 | 77 | 81 | 85 | 87 | 89 | 84 | 79 | 74 | 75 | 72 |

EP 1 653 791 A2

Table 3

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 50 | 56 | 60 | 65 | 67 | 71 | 77 | 81 | 85 | 87 | 91 | 97 | 100 | 104 | 105 | 105 |
| Example 7 (dB) | 50 | 56 | 60 | 65 | 67 | 71 | 77 | 81 | 85 | 87 | 91 | 97 | 100 | 104 | 105 | 105 |
| Example 8 (dB) | 50 | 56 | 60 | 65 | 67 | 71 | 77 | 81 | 85 | 87 | 91 | 97 | 100 | 104 | 105 | 105 |
| Example 9 (dB) | 50 | 56 | 60 | 65 | 67 | 71 | 77 | 81 | 85 | 87 | 91 | 97 | 100 | 104 | 105 | 105 |
| Comparative Example 3 (dB) | 50 | 56 | 60 | 65 | 67 | 71 | 77 | 81 | 85 | 87 | 89 | 84 | 78 | 74 | 75 | 72 |

EP 1 653 791 A2

Table 4

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 50 | 56 | 60 | 65 | 67 | 71 | 77 | 81 | 85 | 87 | 91 | 97 | 100 | 104 | 105 | 105 |
| Example 10 (dB) | 50 | 56 | 60 | 65 | 67 | 71 | 77 | 81 | 85 | 87 | 91 | 97 | 100 | 104 | 105 | 105 |
| Example 11 (dB) | 50 | 56 | 60 | 65 | 67 | 71 | 77 | 81 | 85 | 87 | 91 | 97 | 100 | 104 | 105 | 105 |
| Example 12 (dB) | 50 | 56 | 60 | 65 | 67 | 71 | 77 | 81 | 85 | 87 | 91 | 97 | 100 | 104 | 105 | 105 |
| Comparative Example 4 (dB) | 50 | 56 | 60 | 65 | 67 | 71 | 77 | 81 | 85 | 87 | 91 | 93 | 88 | 84 | 84 | 72 |

Table 5

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 50 | 56 | 60 | 65 | 67 | 71 | 77 | 81 | 85 | 87 | 91 | 97 | 100 | 104 | 105 | 105 |
| Example 13 (dB) | 50 | 56 | 60 | 65 | 67 | 71 | 77 | 81 | 85 | 87 | 91 | 97 | 100 | 104 | 105 | 105 |
| Example 14 (dB) | 50 | 56 | 60 | 65 | 67 | 71 | 77 | 81 | 85 | 87 | 91 | 97 | 100 | 104 | 105 | 105 |
| Example 15 (dB) | 50 | 56 | 60 | 65 | 67 | 71 | 77 | 81 | 85 | 87 | 91 | 97 | 100 | 104 | 105 | 105 |
| Comparative Example 5 (dB) | 50 | 56 | 60 | 65 | 67 | 71 | 77 | 81 | 85 | 87 | 91 | 84 | 80 | 74 | 67 | 63 |
| Comparative Example 6 (dB) | 0 | 0 | 0 | 0 | 0 | 0 | 0 | 0 | 0 | 0 | 0 | 0 | 0 | 0 | 0 | 0 |

Table 6

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 48 | 55 | 58 | 63 | 66 | 69 | 75 | 78 | 83 | 86 | 89 | 97 | 100 | 103 | 102 | 102 |
| Example 16 (dB) | 48 | 55 | 58 | 63 | 66 | 69 | 75 | 78 | 83 | 86 | 89 | 97 | 100 | 103 | 102 | 101 |
| Example 17 (dB) | 48 | 55 | 58 | 63 | 66 | 69 | 75 | 78 | 83 | 86 | 89 | 97 | 100 | 103 | 102 | 102 |
| Example 18 (dB) | 48 | 55 | 58 | 63 | 66 | 69 | 75 | 78 | 83 | 86 | 89 | 97 | 99 | 100 | 100 | 101 |
| Comparative Example 7 (dB) | 48 | 55 | 58 | 63 | 66 | 69 | 75 | 78 | 83 | 86 | 88 | 83 | 76 | 72 | 72 | 68 |

Table 7

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 55 | 63 | 66 | 70 | 73 | 76 | 82 | 85 | 89 | 93 | 94 | 98 | 98 | 96 | 93 | 74 |
| Example 1 (dB) | 17 | 24 | 28 | 34 | 36 | 40 | 46 | 50 | 54 | 58 | 62 | 69 | 74 | 82 | 88 | 74 |
| Example 2 (dB) | 17 | 24 | 27 | 32 | 35 | 38 | 44 | 49 | 54 | 57 | 61 | 68 | 74 | 81 | 87 | 74 |
| Example 3 (dB) | 18 | 24 | 28 | 34 | 36 | 40 | 46 | 50 | 54 | 58 | 62 | 68 | 74 | 82 | 88 | 74 |
| Comparative Example 1 (dB) | 17 | 23 | 26 | 31 | 34 | 37 | 43 | 46 | 52 | 55 | 58 | 66 | 72 | 81 | 88 | 74 |

Table 8

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 55 | 63 | 66 | 70 | 73 | 76 | 82 | 85 | 89 | 93 | 94 | 98 | 98 | 96 | 93 | 74 |
| Example 4 (dB) | 30 | 36 | 40 | 44 | 48 | 52 | 63 | 70 | 84 | 87 | 89 | 96 | 98 | 96 | 93 | 74 |
| Example 5 (dB) | 30 | 36 | 39 | 44 | 47 | 51 | 59 | 66 | 74 | 78 | 82 | 93 | 98 | 96 | 93 | 74 |
| Example 6 (dB) | 30 | 36 | 39 | 44 | 47 | 51 | 60 | 67 | 76 | 79 | 83 | 92 | 98 | 96 | 93 | 74 |
| Comparative Example 2 (dB) | 30 | 36 | 40 | 44 | 47 | 48 | 48 | 48 | 49 | 50 | 51 | 53 | 54 | 54 | 53 | 49 |

Table 9

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 55 | 63 | 66 | 70 | 73 | 76 | 82 | 85 | 89 | 93 | 94 | 98 | 98 | 96 | 93 | 74 |
| Example 7 (dB) | 55 | 55 | 58 | 62 | 64 | 68 | 75 | 82 | 89 | 93 | 94 | 98 | 98 | 96 | 93 | 74 |
| Example 8 (dB) | 54 | 53 | 54 | 57 | 60 | 63 | 70 | 74 | 82 | 87 | 93 | 98 | 98 | 96 | 93 | 74 |
| Example 9 (dB) | 50 | 48 | 50 | 52 | 54 | 56 | 63 | 67 | 74 | 78 | 83 | 94 | 98 | 96 | 93 | 74 |
| Comparative Example 3 (dB) | 52 | 49 | 50 | 50 | 51 | 51 | 52 | 52 | 54 | 55 | 56 | 59 | 61 | 63 | 65 | 56 |

Table 10

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 55 | 63 | 66 | 70 | 73 | 76 | 82 | 85 | 89 | 93 | 94 | 98 | 98 | 96 | 93 | 74 |
| Example 10 (dB) | 50 | 54 | 57 | 60 | 62 | 65 | 73 | 79 | 85 | 90 | 94 | 98 | 98 | 96 | 93 | 74 |
| Example 11 (dB) | 50 | 53 | 56 | 59 | 62 | 64 | 74 | 78 | 84 | 90 | 94 | 98 | 98 | 96 | 93 | 74 |
| Example 13 (dB) | 48 | 51 | 54 | 57 | 60 | 62 | 67 | 70 | 74 | 78 | 82 | 90 | 95 | 96 | 93 | 74 |
| Comparative Example 4 (dB) | 49 | 51 | 52 | 54 | 54 | 54 | 55 | 56 | 58 | 60 | 62 | 65 | 66 | 70 | 67 | 55 |

Table 11

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 55 | 63 | 66 | 70 | 73 | 76 | 82 | 85 | 89 | 93 | 94 | 98 | 98 | 96 | 93 | 74 |
| Example 13 (dB) | 30 | 37 | 40 | 45 | 48 | 52 | 61 | 66 | 75 | 83 | 91 | 98 | 98 | 96 | 93 | 74 |
| Example 14 (dB) | 30 | 37 | 41 | 45 | 48 | 53 | 61 | 66 | 76 | 83 | 91 | 98 | 98 | 96 | 93 | 74 |
| Example 15 (dB) | 30 | 36 | 40 | 44 | 47 | 51 | 59 | 65 | 75 | 84 | 93 | 96 | 98 | 96 | 93 | 74 |
| Comparative Example 5 (dB) | 29 | 35 | 38 | 43 | 45 | 47 | 52 | 54 | 56 | 58 | 60 | 64 | 66 | 70 | 69 | 65 |

Table 12

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 55 | 62 | 66 | 69 | 72 | 75 | 81 | 84 | 88 | 90 | 93 | 98 | 99 | 97 | 94 | 80 |
| Example 16 (dB) | 15 | 22 | 25 | 29 | 33 | 36 | 42 | 45 | 51 | 54 | 56 | 64 | 67 | 72 | 76 | 80 |
| Example 17 (dB) | 16 | 22 | 25 | 30 | 33 | 37 | 43 | 46 | 51 | 54 | 57 | 64 | 67 | 72 | 76 | 80 |
| Example 18 (dB) | 16 | 22 | 25 | 30 | 33 | 36 | 43 | 47 | 52 | 54 | 57 | 64 | 67 | 73 | 76 | 80 |
| Comparative Example 7 (dB) | 13 | 18 | 22 | 26 | 29 | 33 | 38 | 42 | 46 | 48 | 52 | 56 | 60 | 63 | 65 | 66 |

As is clear from Tables 1 to 12 and the graphs as shown in Figs. 9 to 20, it was confirmed that the sheet-like structures A1 to A18 according to Examples 1 to 18 are markedly excellent with respect to the electrical field shielding effect and the magnetic field shielding effect as well as the shielding effect in a high frequency region (in particular, from 100 MHz to 1,000 MHz) as compared with the sheet-like structures B1 to B7 according to Comparative Examples 1 to 7.

Furthermore, since the electromagnetic conducting or absorbing fiber convex structure section composed of an electromagnetic conducting or absorbing fiber is used, not only a thickness effect can be efficiently exhibited, but also a flexible shielding material can be obtained, and therefore, the structure of the invention is easily applicable to various portions.

While the invention has been described in detail and with reference to specific embodiments thereof, it will be apparent to one skilled in the art that various changes and modifications can be made therein without departing from the spirit and scope thereof.

**Claims**

1. A structure having a characteristic of conducting or absorbing electromagnetic waves, which comprises a base material having a characteristic of conducting or absorbing electromagnetic waves; a pressure-sensitive adhesive layer or an adhesive layer formed on at least one surface thereof; and a fiber convex structure section having a characteristic of conducting or absorbing electromagnetic waves formed on the pressure-sensitive adhesive layer or adhesive layer on the at least one surface of the base material in a form that at least a part of a fiber thereof is positioned outward from the surface of the pressure-sensitive adhesive layer or adhesive layer.

2. The structure according to claim 1, wherein the pressure-sensitive adhesive layer or adhesive layer has a characteristic of conducting or absorbing electromagnetic waves.

3. The structure according to claim 1 or 2, wherein the base material having a characteristic of conducting or absorbing electromagnetic waves is a base material containing a material having a characteristic of conducting or absorbing electromagnetic waves on the surface or inside thereof, or a fibrous base material having a characteristic of conducting or absorbing electromagnetic waves.

4. A structure having a characteristic of conducting or absorbing electromagnetic waves, which comprises a substrate having formed thereon a fiber convex structure section having a characteristic of conducting or absorbing electromagnetic waves in a form that at least a part of a fiber thereof is positioned outward from the surface of the substrate, the fiber convex structure section being coated by a coating layer.

5. The structure according to claim 4, wherein the coating layer has a characteristic of conducting or absorbing electromagnetic waves.

6. The structure according to claim 4 or 5, wherein the substrate is at least one layer selected from a pressure-sensitive adhesive layer, an adhesive layer, and a polymer layer.

7. The structure according to any one of claims 4 to 6, wherein the substrate has a characteristic of conducting or absorbing electromagnetic waves.

8. The structure according to any one of claims 4 to 7, wherein the substrate is formed on at least one surface of a support.

9. The structure according to claim 8, wherein the support is a base material containing a material having a characteristic of conducting or absorbing electromagnetic waves on the surface or inside thereof, a foamed body, or a fibrous base material having a characteristic of conducting or absorbing electromagnetic waves.

10. A structure having a characteristic of conducting or absorbing electromagnetic waves, which comprises a pressure-sensitive adhesive layer having formed on one surface of the pressure-sensitive adhesive layer a fiber convex structure section having a characteristic of conducting or absorbing electromagnetic waves in a form that at least a part of a fiber thereof is positioned outward from the surface of the pressure-sensitive adhesive layer, the other surface of the pressure-sensitive adhesive layer serving as a pressure-sensitive adhesive surface.

11. The structure according to claim 10, wherein the pressure-sensitive adhesive layer has a characteristic of conducting or absorbing electromagnetic waves.

**12.** A structure having a characteristic of conducting or absorbing electromagnetic waves, which comprises a substrate having formed on each of the both surfaces thereof a fiber convex structure section having a characteristic of conducting or absorbing electromagnetic waves in a form that at least a part of a fiber thereof is positioned outward from each of the surfaces of the substrate.

**13.** The structure according to claim 12, wherein the substrate is at least one layer selected from a pressure-sensitive adhesive layer, an adhesive layer, and a polymer layer.

**14.** The structure according to claim 12 or 13, wherein the substrate has a characteristic of conducting or absorbing electromagnetic waves.

**15.** The structure according to any one of claims 1 to 14, which is a sheet-like structure having a sheet form.

**16.** The structure according to any one of claims 1 to 15, wherein the fiber convex structure section having a characteristic of conducting or absorbing electromagnetic waves is a fiber napping section having a characteristic of conducting or absorbing electromagnetic waves and having a structure that a fiber stands up from the formed surface.

**17.** The structure according to any one of claims 1 to 16, wherein the fiber convex structure section having a characteristic of conducting or absorbing electromagnetic waves is constructed of at least one kind of a fiber having a characteristic of conducting or absorbing electromagnetic waves selected from a fiber coated by a material having a characteristic of conducting or absorbing electromagnetic waves, a fiber impregnated with a material having a characteristic of conducting or absorbing electromagnetic waves, and a fiber having itself a characteristic of conducting or absorbing electromagnetic waves.

**18.** The structure according to any one of claims 1 to 17, wherein the fiber convex structure section having a characteristic of conducting or absorbing electromagnetic waves is formed by flocking a fiber having a characteristic of conducting or absorbing electromagnetic waves.

**19.** The structure according to any one of claims 1 to 18, wherein the fiber convex structure section having a characteristic of conducting or absorbing electromagnetic waves is constructed of a twisted yarn using two or more kinds of fibers having a characteristic of conducting or absorbing electromagnetic waves.

**20.** The structure according to any one of claims 1 to 19, which is applied as an electrically conductive material.

**21.** The structure according to any one of claims 1 to 19, which is applied as an electromagnetic shielding material.

## FIG. 1A

## FIG. 1B

*FIG. 2A*

*FIG. 2B*

## FIG. 3A

## FIG. 3B

## FIG. 4A

## FIG. 4B

## FIG. 4C

## FIG. 5A

5c
51
5b
5a

## FIG. 5B

5c
52
5b
5a
5b
5c

## FIG. 5C

5c
53
5b
5a
5b

## FIG. 6A

6b  61  6c
6a

## FIG. 6B

6b  62  6c
6a
6c
6b

## FIG. 6C

6b  63  6c
6e
6d

## FIG. 6D

6b  64  6c
6e
6d
6e
6c
6b

## FIG. 6E

6b  65  6c
6e
6d
6e

## FIG. 7

7b  7
7a

## FIG. 8

8b  8
8a
8b

## FIG. 9

GRAPH OF ELECTRICAL FIELD
SHIELDING EFFECT (TABLE 1)

◇ : MEASUREMENT LIMIT
□ : COMPARATIVE EXAMPLE 1
△ : EXAMPLE 1
○ : EXAMPLE 2
× : EXAMPLE 3

# FIG. 10

GRAPH OF ELECTRICAL FIELD
SHIELDING EFFECT (TABLE 2)

◇ : MEASUREMENT LIMIT
□ : COMPARATIVE EXAMPLE 2
△ : EXAMPLE 4
○ : EXAMPLE 5
× : EXAMPLE 6

## FIG. 11

GRAPH OF ELECTRICAL FIELD
SHIELDING EFFECT (TABLE 3)

◇ : MEASUREMENT LIMIT
□ : COMPARATIVE EXAMPLE 3
△ : EXAMPLE 7
○ : EXAMPLE 8
× : EXAMPLE 9

# FIG. 12

GRAPH OF ELECTRICAL FIELD
SHIELDING EFFECT (TABLE 4)

FREQUENCY OF ELECTROMAGNETIC WAVE (MHz)

◇ : MEASUREMENT LIMIT
□ : COMPARATIVE EXAMPLE 4
△ : EXAMPLE 10
○ : EXAMPLE 11
× : EXAMPLE 12

## FIG. 13

GRAPH OF ELECTRICAL FIELD
SHIELDING EFFECT (TABLE 5)

◇ : MEASUREMENT LIMIT
□ : COMPARATIVE EXAMPLE 5
△ : EXAMPLE 13
○ : EXAMPLE 14
× : EXAMPLE 15
+ : COMPARATIVE EXAMPLE 6

# FIG. 14

GRAPH OF ELECTRICAL FIELD
SHIELDING EFFECT (TABLE 6)

◇ : MEASUREMENT LIMIT
□ : COMPARATIVE EXAMPLE 7
△ : EXAMPLE 16
○ : EXAMPLE 17
× : EXAMPLE 18

# FIG. 15

GRAPH OF MAGNETIC FIELD
SHIELDING EFFECT (TABLE 7)

FREQUENCY OF ELECTROMAGNETIC WAVE (MHz)

◇ : MEASUREMENT LIMIT
□ : COMPARATIVE EXAMPLE 1
△ : EXAMPLE 1
○ : EXAMPLE 2
× : EXAMPLE 3

# FIG. 16

GRAPH OF MAGNETIC FIELD
SHIELDING EFFECT (TABLE 8)

◇ : MEASUREMENT LIMIT
□ : COMPARATIVE EXAMPLE 2
△ : EXAMPLE 4
○ : EXAMPLE 5
× : EXAMPLE 6

# FIG. 17

GRAPH OF MAGNETIC FIELD
SHIELDING EFFECT (TABLE 9)

FREQUENCY OF ELECTROMAGNETIC WAVE (MHz)

◇ : MEASUREMENT LIMIT
□ : COMPARATIVE EXAMPLE 3
△ : EXAMPLE 7
○ : EXAMPLE 8
× : EXAMPLE 9

# FIG. 18

GRAPH OF MAGNETIC FIELD
SHIELDING EFFECT (TABLE 10)

◇ : MEASUREMENT LIMIT
□ : COMPARATIVE EXAMPLE 4
△ : EXAMPLE 10
○ : EXAMPLE 11
× : EXAMPLE 12

# FIG. 19

GRAPH OF MAGNETIC FIELD
SHIELDING EFFECT (TABLE 11)

◇ : MEASUREMENT LIMIT
□ : COMPARATIVE EXAMPLE 5
△ : EXAMPLE 13
○ : EXAMPLE 14
× : EXAMPLE 15

# FIG. 20

**GRAPH OF MAGNETIC FIELD
SHIELDING EFFECT (TABLE 12)**

◇ : MEASUREMENT LIMIT
□ : COMPARATIVE EXAMPLE 7
△ : EXAMPLE 16
○ : EXAMPLE 17
× : EXAMPLE 18

## FIG. 21A

CENTRAL CONDUCTOR

EXTERNAL CONDUCTOR

INPUT AND OUTPUT

80mm

100mm

50mm

230mm

## FIG. 21B

LOOP ANTENNA

BNC CONNECTOR

2mm

50Ω

RADIUS: 22mm